# EUROPEAN PATENT APPLICATION

(11) **EP 4 844 807 A1**
(43) Date of publication of application: **25.11.2026**
(21) Application number: 25741953.1
(22) Date of filing: 15.01.2025
(51) Int. Cl.: H01L 21/304

(54) **CLEANING LIQUID FOR SEMICONDUCTOR SUBSTRATE, METHOD FOR CLEANING OBJECT TO BE PROCESSED, AND METHOD FOR MANUFACTURING SEMICONDUCTOR DEVICE**

(30) Priority: 19.01.2024 US 202463622540 P
(71) Applicant: FUJIFILM Corporation, Tokyo 106-8620 (JP); FUJIFILM Electronic Materials U.S.A., Inc., N. Kingstown, RI 02852 (US)
(72) Inventor: MIURA, Daiyo, Haibara-gun, Shizuoka 421-0396 (JP); SHIGENOI, Yuta, Haibara-gun, Shizuoka 421-0396 (JP); MIZUTANI, Atsushi, Haibara-gun, Shizuoka 421-0396 (JP); SUGIMURA, Nobuaki, Mesa, Arizona 85212 (US)
(74) Representative: HGF
(86) International application number: PCT/JP2025/000982
(87) International publication number: WO 2025/154728

(57) **Abstract**

The present invention provides a cleaning solution for a semiconductor substrate that, when used for a target object having a copper surface and a silicon carbonitride surface that have been subjected to chemical mechanical polishing processing, exhibits a high ability to clean the copper surface and the silicon carbonitride surface and is less corrosive to copper. The cleaning solution of the invention for a semiconductor substrate includes a compound represented by formula (A) and a polymer having a group selected from the group consisting of a carboxy group and salts thereof and a sulfonic acid group and salts thereof and has a pH of 7.5 or more.

## Description

### Technical Field

The present invention relates to a cleaning solution for a semiconductor substrate, a method for cleaning a target object, and a method for manufacturing a semiconductor device.

### Background Art

A semiconductor element is manufactured by forming a resist film on a layered body including a metal film serving as a wiring material, an etch stop layer, and an interlayer insulating layer that are disposed on a substrate and then performing a photolithography step. In one widely known method, a process solution that can dissolve metals and/or organic materials is used in the photolithography step to perform etching or remove foreign substances on the surface of the substrate.

Moreover, in the manufacture of semiconductor elements, the surface of a semiconductor substrate including a metal wiring film, a barrier metal, an insulating film, etc. is, in some cases, subjected to chemical mechanical polishing (CMP) processing for planarizing the surface using a polishing slurry including fine abrasive particles (such as silica or alumina).

In the CMP processing, the fine abrasive particles used for the CMP processing and metal components derived from the polished wiring metal film and/or the polished barrier metal tend to remain on the polished surface of the semiconductor substrate. Therefore, the step of removing these residual materials using a process solution is generally performed after the CMP processing.

One example of the process solution used in the cleaning step is a composition disclosed in PTL 1. This composition is used to clean a semiconductor wafer by removing contaminants after the chemical mechanical polishing and is "a cleaning composition including one or more quaternary ammonium hydroxides, one or more organic amines, one or more metal inhibitors, and water."

### Citation List

### Patent Literature

PTL 1: JP2018-507540A

### Summary of Invention

### Technical Problem

The present inventors have conducted studies on the ability of the post-CMP cleaning composition described in PTL 1 to clean a copper surface and a silicon carbonitride surface of a target object subjected to CMP processing (for example, the ability to remove organic residues). The inventors have found that it is difficult to achieve both the ability to clean the copper surface and the silicon carbonitride surface and the inhibition of corrosion of the copper surface simultaneously.

Accordingly, it is an object of the invention to provide a cleaning solution for a semiconductor substrate that, when used for a target object having a copper surface and a silicon carbonitride surface that have been subjected to chemical mechanical polishing processing, exhibits a high ability to clean the copper surface and the silicon carbonitride surface and is less corrosive to copper.

It is another object of the invention to provide a method for cleaning a target object using the cleaning solution for a semiconductor substrate and a method for manufacturing a semiconductor device.

### Solution to Problem

The present inventors have conducted extensive studies to solve the foregoing problem and found that the problem can be solved by the following aspects.
[1] A cleaning solution for a semiconductor substrate, the cleaning solution including:
   a compound represented by formula (A) described later; and
   a polymer having a group selected from the group consisting of a carboxy group and salts thereof and a sulfonic acid group and salts thereof,
   wherein the cleaning solution has a pH of 7.5 or more.
[2] The cleaning solution for a semiconductor substrate according to [1], wherein R₅ and R₆ are each a hydrogen atom.
[3] The cleaning solution for a semiconductor substrate according to [1] or [2], wherein R₁ to R₈ each independently represent a hydrogen atom or an alkyl group optionally having a substituent other than a carboxy group, a phosphonic acid group, and a hydroxy group, and
   wherein at least one of R₁, R₂, R₃, or R₄ represents an alkyl group optionally having a substituent other than a carboxy group, a phosphonic acid group, a hydroxy group, and an amino group.
[4] The cleaning solution for a semiconductor substrate according to any one of [1] to [3], wherein R₁ and R₂ are each a hydrogen atom, and wherein at least one of R₃ or R₄ is an alkyl group optionally having a substituent other than a carboxy group and a phosphonic acid group.
[5] The cleaning solution for a semiconductor substrate according to any one of [1] to [4], wherein the polymer has a weight average molecular weight of 4000 or more.
[6] The cleaning solution for a semiconductor substrate according to any one of [1] to [5], wherein the cleaning solution has a pH of 10.0 or more.
[7] The cleaning solution for a semiconductor substrate according to any one of [1] to [6], wherein the cleaning solution has a pH of 11.0 or more.
[8] The cleaning solution for a semiconductor substrate according to any one of [1] to [7], wherein the cleaning solution further includes a corrosion inhibitor.
[9] The cleaning solution for a semiconductor substrate according to [8], wherein the corrosion inhibitor includes at least one of a compound represented by formula (C) described later or a compound represented by formula (D) described later.
[10] The cleaning solution for a semiconductor substrate according to any one of [1] to [9], wherein a ClogP value of the compound represented by formula (A) above is a negative value.
[11] The cleaning solution for a semiconductor substrate according to any one of [1] to [10], wherein the number of carbon atoms in the compound represented by formula (A) above is 5 or less.
[12] The cleaning solution for a semiconductor substrate according to any one of [1] to [11], wherein the cleaning solution includes water.
[13] The cleaning solution for a semiconductor substrate according to any one of [1] to [12], wherein the cleaning solution is used to clean a target object subjected to chemical mechanical polishing processing.
[14] The cleaning solution for a semiconductor substrate according to [13], wherein the target object has a copper surface and a silicon carbonitride surface that have been subjected to chemical mechanical polishing processing, and wherein the cleaning solution is used to clean the copper surface and the silicon carbonitride surface.
[15] A method for cleaning a target object, the method including the step of bringing a target object having a copper surface and a silicon carbonitride surface that have been subjected to chemical mechanical polishing processing into contact with the cleaning solution for a semiconductor substrate according to any one of [1] to [14].
[16] The method for cleaning a target object according to [15], wherein the step is cleaning with a polishing pad, buff cleaning, cleaning by an immersion method, spin cleaning, or scrub cleaning.
[17] A method for manufacturing a semiconductor device, the method including the method for cleaning a target object according to [15] or [16].

### Advantageous Effects of Invention

The present invention can provide a cleaning solution for a semiconductor substrate that, when used for a target object having a copper surface and a silicon carbonitride surface that have been subjected to chemical mechanical polishing processing, exhibits a high ability to clean the copper surface and the silicon carbonitride surface and is less corrosive to copper.

The present invention can also provide a method for cleaning a target object using the cleaning solution for a semiconductor substrate and a method for manufacturing a semiconductor device.

### Description of Embodiments

The present invention will next be described in detail.

The structural requirements described below may be based on representative embodiments of the present invention. However, the invention is not limited to these embodiments.

The meanings of notations in the present specification will be described.

In the present specification, a numerical range represented using "to" means a range including the numerical values before and after the "to" as the minimum value and the maximum value, respectively.

In the present specification, the "total mass of solids" means the total mass of all components included in the cleaning solution other than solvents such as water and an organic solvent.

In the present specification, when two or more types of the same component are present, the "content" of the component means the total content of the two or more types of the component.

A compound described in the present specification may include constitutional isomers, optical isomers, or isotopes, unless otherwise specified. Only one constitutional isomer, optical isomer, or isotope may be included, or two or more constitutional isomers, optical isomers, or isotopes may be included.

In the present specification, when a plurality of substituents, linking groups, etc. (hereinafter referred to as substituents etc.) represented by a specific symbol are present or a plurality of substituents etc. are specified at the same time, the substituents etc. may be the same or different from each other. The same applies to the definition of the number of substituents etc.

No limitation is imposed on the bonding direction of a divalent group in the present specification, unless otherwise specified. For example, when Y in a compound represented by a general formula "X-Y-Z" is -COO-, Y may be -CO-O- or may be -O-CO-. This compound may be "X-CO-O-Z" or may be "X-O-CO-Z."

In the present specification, the ClogP value is a computational value of the common logarithm logP of the partition coefficient P in 1-octanol and water. A well-known method and software may be used for the computation of the ClogP value, or a well-known literature value (for example, a value reported in Web sites such as http://www.chemspider.com) may be used.

In the present invention, a structure is drawn using ChemDraw Professional (version 20.1.1) manufactured by PerkinElmer, and a value computed using the above software is used, unless otherwise specified.

In the present specification, "(meth)acrylic" is a generic term for acrylic and methacrylic and means "at least one of acrylic or methacrylic." Similarly, "(meth)acrylic acid" means "at least one of acrylic acid or methacrylic acid."

In the present specification, the molecular weight of a compound having a molecular weight distribution is its weight average molecular weight.

In the present specification, when a polymer used is a commercial product and catalog values (nominal values provided by the manufacturer) of the weight average molecular weight (Mw), number average molecular weight (Mn), and polydispersity (which may be referred to also as the molecular weight distribution) (Mw/Mn) of the polymer are provided, the catalog values are used.

When no catalog values etc. are provided or the weight average molecular weight (Mw), number average molecular weight (Mn), and polydispersity(Mw/Mn) of the polymer are determined by measurement, the weight average molecular weight (Mw), number average molecular weight (Mn), and polydispersity (Mw/Mn) are defined as polystyrene equivalent values determined by GPC (Gel Permeation Chromatography) measurement using a GPC apparatus (Prominence UFLC manufactured by Shimadzu Corporation) (eluant: solution containing phosphate buffer (pH = 7) and acetonitrile at a volume ratio of 9:1, flow rate (injection amount of sample): 50 µL, columns: TSK guard column α + TSK gel α-6000 + TSK gel α-3000 manufactured by TOSOH Corporation, column temperature: 40°C, flow rate: 1.0 mL/minute, detector: differential refractometer (refractive index detector)). The notation "TSK guard column α + TSK gel α-6000 + TSK gel α-3000" means that these three columns connected to each other are used.

In the present specification, "ppm" means "parts-per-million (10⁻⁶)," and "ppb" means "parts-per-billion (10⁻⁹)."

In the present specification, 1 Å (angstrom) corresponds to 0.1 nm.

### [Cleaning solution]

The cleaning solution of the invention is a cleaning solution for a semiconductor substrate that includes a compound represented by formula (A) described later and a polymer (hereinafter referred to as a "specific polymer") having a group selected from the group consisting of a carboxy group and salts thereof and a sulfonic acid group and salts thereof and that has a pH of 7.5 or more.

The mechanism that allows the cleaning solution of the invention having the structure described above to solve the problem in the invention is not clear, but the inventors infer that the mechanism is as follows.

However, the following inference does not limit the mechanism that produces the effect. In other words, even when the effect is obtained through a mechanism other than the following mechanism, the mechanism is included in the scope of the invention.

On a copper surface subjected to chemical mechanical polishing (CMP), aggregates formed by complexation of copper caused by polishing with components included in the CMP slurry, etc. are present as organic residues. However, the compound represented by formula (A) can disperse the aggregates, and therefore the organic residues can be easily transferred to the cleaning solution.

Moreover, since the silicon carbonitride (SiCN) surface and also the organic residues have hydrophobicity, the organic residues are not easily removed. However, since the polymer has a carboxy group or a sulfonic acid group as a hydrophilic moiety, the polymer has the effect of preventing re-adhesion of the organic residues to the SiCN surface.

The inventors have also found that the polymer having a carboxy group and a sulfonic acid group is less corrosive to copper, although the details of the mechanism are unclear.

It is therefore considered that, when used for a target object having a copper surface and a silicon carbonitride surface that have been subjected to chemical mechanical polishing processing, the cleaning solution of the invention exhibits a high ability to clean the copper surface and the silicon carbonitride surface and is less corrosive to copper.

The components included in the cleaning solution of the invention will next be described in detail.

In the present specification, when the cleaning solution is used for a target object having a copper surface and a silicon carbonitride surface that have been subjected to chemical mechanical polishing processing and at least one effect selected from the group consisting of the high ability to clean the copper surface, the high ability to clean the silicon carbonitride surface, and the low corrosiveness to copper is obtained, it is said that "the effects of the invention are higher."

### [Compound represented by formula (A)]

The cleaning solution of the invention includes the compound represented by formula (A) described later. On the copper surface subjected to CMP processing, a large amount of aggregates of copper and a corrosion inhibitor (such as benzotriazole) derived from the CMP slurry are present as organic residues. However, the compound represented by formula (A) in the cleaning solution replaces the corrosion inhibitor coordinated to copper to thereby disintegrate the aggregates, and dissolution of the organic residues into the cleaning solution is facilitated. Specifically, when the compound represented by formula (A) is included, the ability of the cleaning solution to clean the copper surface is enhanced.

The number of carbon atoms in the compound represented by formula (A) is preferably 2 to 10, more preferably 2 to 6, and still more preferably 2 to 5.

The ClogP value of the compound represented by formula (A) is preferably -5.00 to 1.00, more preferably -2.00 to - 0.01, and still more preferably -1.50 to -0.10.

In particular, the ClogP value is preferably a negative value. When the ClogP value of the compound represented by formula (A) is a negative value, the compound represented by formula (A) becomes more hydrophilic when coordinated to copper, so that the ability of the cleaning solution to clean the copper surface is further enhanced.

The structure of formula (A) is as follows.

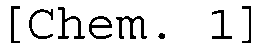

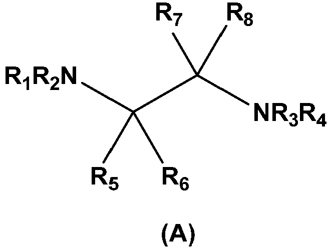

In formula (A), R₁ to R₈ each independently represent a hydrogen atom or an alkyl group optionally having a substituent other than a carboxy group and a phosphonic acid group.

At least one of R₁, R₂, R₃, or R₄ represents an alkyl group optionally having a substituent other than a carboxy group, a phosphonic acid group, and an amino group.

The number of carbon atoms in the alkyl group is preferably 1 to 30, more preferably 1 to 15, and still more preferably 1 to 6. The number of carbon atoms in the alkyl group does not include carbon atoms in the substituent.

Examples of the substituent other than a carboxy group and a phosphonic acid group include: halogen atoms such as a fluorine atom, a chlorine atom, and a bromine atom; alkoxy groups; acyl groups such as an acetyl group, a propionyl group, and a benzoyl group; a cyano group; and a nitro group.

The substituent other than a carboxy group and a phosphonic acid group may be an amino group. The amino group is preferably a group represented by -NR^{N}₂ (R^{N} represents a hydrogen atom or an alkyl group having 1 to 6 carbon atoms).

The number of optional substituents on the alkyl group is preferably 0 to 5, more preferably 0 to 3, and still more preferably 0.

The optional substituent on the alkyl group is the substituent other than a carboxy group and a phosphonic acid group as described above and is preferably a substituent other than a carboxy group, a phosphonic acid group, and a hydroxy group.

Specifically, in formula (A) above, R₁ to R₈ each independently represent a hydrogen atom or an alkyl group optionally having a substituent other than a carboxy group, a phosphonic acid group, and a hydroxy group, and it is preferable that at least one of R₁, R₂, R₃, or R₄ represents an alkyl group optionally having a substituent other than a carboxy group, a phosphonic acid group, a hydroxy group, and an amino group.

Among R₁ to R₈, R₅ and R₆ are each preferably a hydrogen atom, and it is more preferable that R₅ to R₈ are each a hydrogen atom.

As described above, at least one of R₁, R₂, R₃, or R₄ represents an alkyl group optionally having a substituent other than a carboxy group, a phosphonic acid group, and an amino group. It is preferable that one or two selected from the group consisting of R₁ to R₄ each represent an alkyl group optionally having a substituent other than a carboxy group, a phosphonic acid group, and an amino group.

More specifically, R₁ and R₂ are each preferably a hydrogen atom. Moreover, it is preferable that at least one of R₃ or R₄ is an alkyl group optionally having a substituent other than a carboxy group, a phosphonic acid group, and an amino group, and it is more preferable that one of R₃ or R₄ is an alkyl group optionally having a substituent other than a carboxy group, a phosphonic acid group, and an amino group and that the other one is a hydrogen atom.

When at least one of R₁, R₂, R₃, or R₄ represents an alkyl group optionally having a substituent other than a carboxy group, a phosphonic acid group, a hydroxy group, and an amino group as described above, it is preferable that one or two selected from the group consisting of R₁ to R₄ each represent an alkyl group optionally having a substituent other than a carboxy group, a phosphonic acid group, a hydroxy group, and an amino group.

More specifically, R₁ and R₂ are each preferably a hydrogen atom. Moreover, it is preferable that at least one of R₃ or R₄ is an alkyl group optionally having a substituent other than a carboxy group, a phosphonic acid group, a hydroxy group, and an amino group, and it is more preferable that one of R₃ or R₄ is an alkyl group optionally having a substituent other than a carboxy group, a phosphonic acid group, a hydroxy group, and an amino group and that the other one is a hydrogen atom.

In particular, it is preferable that R₁ and R₂ are each a hydrogen atom and that at least one of R₃ or R₄ is an alkyl group optionally having a substituent other than a carboxy group and a phosphonic acid group (more preferably an alkyl group having no substituent) because the effects of the invention are further enhanced.

When R₁ and R₂ and are each a hydrogen atom, the compound represented by formula (A) can easily coordinate to copper as described above, and the ability of the cleaning solution to clean the copper surface is further enhanced. When at least one of R₃ or R₄ is an alkyl group optionally having a substituent other than a carboxy group and a phosphonic acid group, the effect of the compound represented by formula (A) on corrosion of the copper surface of the target object subjected to chemical mechanical polishing processing can be reduced.

In formula (A), R₃ and R₇ may be bonded together via a single bond or a divalent linking group to form a ring, and R₁ and R₃ may be bonded together via a single bond or a divalent linking group to form a ring. However, it is preferable that the compound represented by formula (A) has no ring formed therein.

Examples of the divalent linking group include divalent hydrocarbon groups (divalent aliphatic hydrocarbon groups such as alkylene groups (having preferably 1 to 10 carbon atoms and more preferably 1 to 5 carbon atoms), alkenylene groups (having preferably 1 to 10 carbon atoms and more preferably 1 to 5 carbon atoms), and alkynylene groups (having preferably 1 to 10 carbon atoms and more preferably 1 to 5 carbon atoms) and divalent aromatic hydrocarbon groups such as an arylene group), divalent heterocyclic groups, -O-, -S-, -SO₂-, -NH-, -N(Q)-, -CO-, and combinations of any of the above groups (such as -O-divalent hydrocarbon group-, -(O-divalent hydrocarbon group)ₘ-O- (m is an integer of 1 or more), and -divalent hydrocarbon group-O-CO-). Q represents a hydrogen atom or an alkyl group.

When a pair of R₃ and R₇ and a pair of R₁ and R₃ each form a ring, the number of atoms forming the ring is preferably 3 to 20, more preferably 3 to 10, and still more preferably 5 to 6.

The ring formed from R₃ and R₇ bonded together and the ring formed from R₁ and R₃ bonded together are each preferably a nitrogen-containing alicyclic structure. The number of ring member atoms in each ring is preferably 3 to 8 and more preferably 5 or 6.

Specific examples of the rings include piperidine, derivatives thereof, piperazine, and derivatives thereof.

The molecular weight of the compound represented by formula (A) is preferably 50 to 500, more preferably 50 to 300, still more preferably 50 to 200, and particularly preferably 50 to 100.

One compound represented by formula (A) may be used alone, or a combination of two or more may be used.

The content of the compound represented by formula (A) with respect to the total mass of the cleaning solution is preferably 0.0001 to 10.0% by mass, more preferably 0.0001 to 1.0% by mass, and still more preferably 0.001 to 1.0% by mass.

The mass ratio of the amount of the compound represented by formula (A) with respect to the total amount of solids in the cleaning solution is preferably 0.001 to 10.0, more preferably 0.001 to 1.0, and still more preferably 0.01 to 1.0.

### [Specific polymer]

The cleaning solution of the invention includes a polymer (specific polymer) having a group selected from the group consisting of a carboxy group and salts thereof and a sulfonic acid group and salts thereof.

Preferably, the specific polymer has a hydrophilic moiety derived from a group selected from the group consisting of a carboxy group and salts thereof and a sulfonic acid group and salts thereof (this group is hereinafter referred to as an "anionic functional group") and a hydrophobic moiety (for example, a moiety derived from the main chain).

The specific polymer may have the hydrophilic moiety and the hydrophobic moiety. In this case, when the cleaning solution of the invention is applied to a target object having a copper (Cu) surface and a silicon carbonitride (SiCN) surface that have been subjected to chemical mechanical polishing processing, although the silicon carbonitride surface has hydrophobicity, the surface coated with the specific polymer becomes hydrophilic, and the effect of preventing re-adhesion of hydrophobic organic residues removed from the silicon carbonitride surface may thereby be obtained.

Moreover, when the specific polymer does not have a cationic functional group but has the anionic functional group, the amount of corrosion of copper can be reduced.

Preferably, the specific polymer is a polymer including a repeating unit having the anionic functional group (this repeating unit is hereinafter referred to also as a "repeating unit A").

As described later, the specific polymer may have a repeating unit other than the repeating unit A but is preferably a polymer including only the repeating unit A. The specific polymer may have two or more types of repeating units A.

### <Repeating unit A>

The repeating unit A is a repeating unit having a group (anionic functional group) selected from the group consisting of a carboxy group and salts thereof and a sulfonic acid group and salts thereof.

Examples of the salts of a carboxy group and the salts of a sulfonic acid group include ammonium salts, potassium salts, sodium salts, and lithium salts.

No particular limitation is imposed on the number of acid groups or salt groups thereof included in the repeating unit A, but the number of acid groups or salt groups thereof is preferably 1 to 4, more preferably 1 to 3, and still more preferably 1 or 2.

The specific polymer is preferably a polymer including only a repeating unit A selected from the group consisting of a repeating unit having a carboxy group or a salt thereof and a repeating unit having a sulfonic acid group or a salt thereof because the effects of the invention are further enhanced and is more preferably a polymer including only a repeating unit A having a carboxy group or a salt thereof or a polymer including only a repeating unit A having a sulfonic acid group or a salt thereof.

Examples of the repeating unit A include a repeating unit derived from a compound having an anionic functional group and an ethylenically unsaturated group.

Specific examples of the anionic functional group are as described above.

The ethylenically unsaturated group is a functional group having an ethylenically unsaturated bond. Examples of the ethylenically unsaturated group include aromatic vinyl groups, an acryloyloxy group (CH₂=CH-COO-), a methacryloyloxy group (CH₂=CCH₃-COO-), an acrylamido group (CH₂=CH-CONH-), a methacrylamido group (CH₂=CCH₃-CONH-), a maleimide group, a vinyl group, and a vinyl ether group.

The ethylenically unsaturated group is preferably an aromatic vinyl group, an acryloyloxy group, a methacryloyloxy group, an acrylamido group, or a vinyl group. The aromatic vinyl group is preferably a styryl group.

The repeating unit A is preferably a repeating unit represented by formula (a).

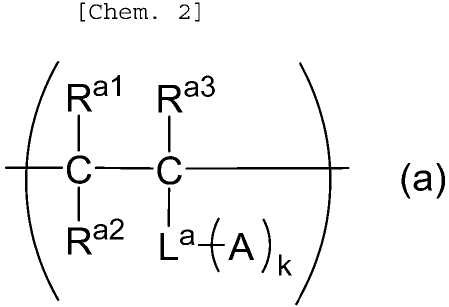

In formula (a), R^{a1}, R^{a2}, and R^{a3} each independently represent a hydrogen atom, an alkyl group having 1 to 4 carbon atoms, or an anionic functional group.

L^{a} represents a single bond or a (k + 1) valent linking group.

A represents an anionic functional group.

k represents an integer of 1 to 4.

When a plurality of anionic functional groups are present in formula (a), the plurality of anionic functional groups may be the same or different.

When L^{a} is a single bond, k represents 1.

R^{a1}, R^{a2}, and R^{a3} are each preferably a hydrogen atom, a halogen atom (a fluorine atom, a chlorine atom, a bromine atom, or an iodine atom), a methyl group, an ethyl group, a carboxy group, or a salt thereof and more preferably a hydrogen atom, a methyl group, a carboxy group, or a salt thereof.

In particular, it is preferable that one of R^{a1}, R^{a2}, or R^{a3} represents a hydrogen atom, a methyl group, a carboxy group, or a salt thereof and that the remaining two each represent a hydrogen atom.

No particular limitation is imposed on the (k + 1) valent linking group represented by L^{a}, so long as the valence of the group is equal to the number of A's. Examples of the (k + 1) valent linking group include divalent to pentavalent aliphatic hydrocarbon groups optionally having a substituent, divalent to pentavalent aromatic hydrocarbon groups optionally having a substituent, divalent to pentavalent aromatic heterocyclic groups optionally having a substituent, -O-, -CO-, -SO₂-, -NR^{L}-, - N<, and groups formed by combining any of these groups. RL represents a hydrogen atom or a monovalent aliphatic hydrocarbon group.

The aliphatic hydrocarbon group may be a linear, branched chain, or cyclic group.

k is preferably 1. In this case, the divalent linking group represented by L^{a} is a divalent aliphatic hydrocarbon group, a divalent aromatic hydrocarbon group, a divalent heterocyclic group, -O-, -CO-, -SO₂-, -NR^{L}-, and a group formed by combining any of these groups and is preferably a single bond, -CO-O-, -CO-NH-, an alkylene group having 1 to 5 carbon atoms, a phenylene group, or a group formed by combining any of these groups.

The anionic functional group represented by A is preferably a carboxy group or a salt thereof.

k represents an integer of 1 to 4 and is preferably 1 or 2.

Examples of the repeating unit A include repeating units derived from compounds selected from the group consisting of acrylic acid, maleic acid, itaconic acid, vinylacetic acid, allylacetic acid, fumaric acid, p-styrene sulfonic acid, vinylsulfonic acid, and 2-acrylamido-2-methyl-1-propanesulfonic acid.

No particular limitation is imposed on the content of the repeating unit A, but the content of the repeating unit A with respect to the total amount of repeating units in the specific polymer is preferably 50 to 100% by mole, more preferably 75 to 100% by mole, and still more preferably 90 to 100% by mole.

### <Repeating unit B>

The specific polymer may include a repeating unit B different from the repeating unit A.

No particular limitation is imposed on the repeating unit B. Examples of the repeating unit B include repeating units derived from compounds selected from the group consisting of aromatic vinyl compounds, alkyl (meth)acrylate compounds optionally having a hydroxy group, unsaturated alcohol compounds, aliphatic conjugated diene compounds, vinyl cyan compounds, and amide compounds having a polymerizable double bond.

Examples of the aromatic vinyl compounds include styrene, α-methylstyrene, vinyltoluene, and p-methylstyrene.

No particular limitation is imposed on the content of the repeating unit B. However, the content of the repeating unit B with respect to the total amount of the repeating units in the specific polymer is preferably 0.1 to 50% by mole, more preferably 1 to 25% by mole, and still more preferably 1 to 15% by mole.

Preferably, the specific polymer is selected from the group consisting of polyacrylic acid, polystyrene sulfonic acid, polyvinylsulfonic acid, poly(2-acrylamido-2-methyl-1-propanesulfonic acid), 2-acrylamido-2-methyl-1-propanesulfonic acid-acrylic acid copolymers, and styrene sulfonic acid-acrylic acid-vinyl phosphonic acid copolymers.

The weight average molecular weight of the specific polymer is preferably 500 to 80000, more preferably 1000 to 30000, still more preferably 3000 to 20000, and particularly preferably 4000 to 10000.

One specific polymer may be used alone, or a combination of two or more may be used.

The content of the specific polymer with respect to the total mass of the cleaning solution is preferably 0.0001 to 10.0% by mass, more preferably 0.0001 to 1.0% by mass, and still more preferably 0.001 to 1.0% by mass.

The mass ratio of the amount of the specific polymer with respect to the total amount of the solids in the cleaning solution is preferably 0.0001 to 10.0, more preferably 0.001 to 1.0, and still more preferably 0.01 to 1.0.

### [Corrosion inhibitor]

Preferably, the cleaning solution of the invention includes a corrosion inhibitor because the effects of the invention are further enhanced.

The corrosion inhibitor coordinates to the copper surface and exhibits the effect of inhibiting the corrosion of copper.

No particular limitation is imposed on the corrosion inhibitor, and any well-known corrosion inhibitor can be used. Preferably, an azole compound is used.

The azole compound is a compound having a five-membered heterocycle that includes at least one nitrogen atom and has aromaticity. No particular limitation is imposed on the number of nitrogen atoms included in the five-membered heterocycle included in the azole compound. The number of nitrogen atoms is preferably 1 to 4 and more preferably 2 to 4.

The azole compound may have a substituent on the five-membered heterocycle. Examples of the substituent include a hydroxy group, a carboxy group, a mercapto group, halogen atoms, a nitro group, alkoxy groups, an amino group, and substituted and unsubstituted hydrocarbon groups.

When two substituents are adjacent to each other on the five-membered heterocycle, these two substituents may be bonded together to form a ring.

Examples of the hydrocarbon group included as a substituent on the 5-membered heterocycle include alkyl groups (having preferably 1 to 12 carbon atoms and more preferably 1 to 6 carbon atoms), alkenyl groups (having preferably 2 to 12 carbon atoms and more preferably 2 to 6 carbon atoms), alkynyl groups (having preferably 2 to 12 carbon atoms and more preferably 2 to 6 carbon atoms), aryl groups (having preferably 6 to 18 carbon atoms and more preferably 6 to 10 carbon atoms), and aralkyl groups (having preferably 7 to 23 carbon atoms and more preferably 7 to 11 carbon atoms).

Examples of the substituent that the hydrocarbon group has include a hydroxy group, a carboxy group, and - N(Ra)(Rb). Ra and Rb each independently represent a hydrogen atom, an alkyl group (having preferably 1 to 6 carbon atoms and more preferably 1 to 4 carbon atoms), or a hydroxyalkyl group (having preferably 1 to 6 carbon atoms and more preferably 1 to 4 carbon atoms).

No particular limitation is imposed on the ring formed by bonding the two adjacent substituents on the five-membered heterocycle, but the ring is preferably an aromatic ring (which may be a monocyclic ring or a polycyclic ring) and more preferably a benzene ring.

The ring formed by bonding the two adjacent substituents may have a substituent. No particular limitation is imposed on the substituent, and examples thereof include those exemplified for the substituent in the hydrocarbon group included in the five-membered heterocycle.

Examples of the azole compound include imidazole compounds in which one of the atoms forming the azole ring is a nitrogen atom, pyrazole compounds in which two of the atoms forming the azole ring are each a nitrogen atom, thiazole compounds in which one of the atoms forming the azole ring is a nitrogen atom and another one is a sulfur atom, triazole compounds in which three of the atoms forming the azole ring are each a nitrogen atom, and tetrazole compounds in which four of the atoms forming the azole ring are each a nitrogen atom.

Examples of the imidazole compounds include imidazole, 1-methylimidazole, 2-methylimidazole, 5-methylimidazole, 1,2-dimethylimidazole, 2-mercaptoimidazole, 4,5-dimethyl-2-mercaptoimidazole, 4-hydroxyimidazole, 2,2'-biimidazole, 4-imidazolecarboxylic acid, histamine, a benzimidazole compound having a benzimidazole skeleton formed by condensation of an imidazole ring and a benzene ring, and a purine compound having a purine skeleton formed by condensation of an imidazole ring and a pyrimidine ring.

Examples of the benzimidazole compound include benzimidazole, 2-aminobenzimidazole, and 2-mercaptobenzimidazole.

Examples of the pyrazole compounds include pyrazole, 4-pyrazolecarboxylic acid, 1-methylpyrazole, 3-methylpyrazole, 4-methylpyrazole, 3-amino-5-hydroxypyrazole, 3-aminopyrazole, 3-amino-5-tert-butyl-1H-pyrazole, and 4-aminopyrazole.

Examples of the thiazole compounds include 2,4-dimethylthiazole, benzothiazole, and 2-mercaptobenzothiazole.

The triazole compound is preferably a compound having a benzotriazole skeleton formed by bonding two adjacent substituents on the triazole ring together to form a benzene ring.

Examples of the benzotriazole compound include benzotriazole (BTA), 5-aminotetrazole, 1-hydroxybenzotriazole, 5-phenylthiol-benzotriazole, 5-chlorobenzotriazole, 4-chlorobenzotriazole, 5-bromobenzotriazole, 4-bromobenzotriazole, 5-fluorobenzotriazole, 4-fluorobenzotriazole, naphthotriazole, tolyltriazole, 5-phenyl-benzotriazole, 5-nitrobenzotriazole, 4-nitrobenzotriazole, 3-amino-5-mercapto-1,2,4-triazole, 2-(5-amino-pentyl)-benzotriazole, 1-amino-benzotriazole, 5-methyl-1H-benzotriazole (5MBTA), benzotriazole-5-carboxylic acid, 4-methylbenzotriazole, 4-ethylbenzotriazole, 5-ethylbenzotriazole, 4-propylbenzotriazole, 5-propylbenzotriazole, 4-isopropylbenzotriazole, 5-isopropylbenzotriazole, 4-n-butylbenzotriazole, 5-n-butylbenzotriazole, 4-isobutylbenzotriazole, 5-isobutylbenzotriazole, 4-pentylbenzotriazole, 5-pentylbenzotriazole, 4-hexylbenzotriazole, 5-hexylbenzotriazole, 5-methoxybenzotriazole, 5-hydroxybenzotriazole, dihydroxypropylbenzotriazole, 1-[N,N-bis(2-ethylhexyl)aminomethyl]-benzotriazole, 5-t-butylbenzotriazole, 5-(1',1'-dimethylpropyl)-benzotriazole, 5-(1',1',3'-trimethylbutyl)benzotriazole, 5-n-octylbenzotriazole, and 5-(1',1',3',3'-tetramethylbutyl)benzotriazole.

Examples of the triazole compound other than the compounds having a benzotriazole skeleton include 1,2,4-triazole, 3-methyl-1,2,4-triazole, 3-amino-1,2,4-triazole, 1,2,3-triazole, and 1-methyl-1,2,3-triazole.

Examples of the tetrazole compound include 1H-tetrazole (1,2,3,4-tetrazole), 5-methyl-1,2,3,4-tetrazole, 5-amino-1H-tetrazole, 1,5-pentamethylenetetrazole, 1-phenyl-5-mercaptotetrazole, and 1-(2-dimethylaminoethyl)-5-mercaptotetrazole.

It is preferable that the corrosion inhibitor included is at least one of a compound represented by formula (C) or a compound represented by formula (D) because the effects of the invention are further enhanced, and it is more preferable that the corrosion inhibitor included is the compound represented by formula (C). The compound represented by formula (C) and the compound represented by formula (D) are preferred because they are unlikely to remain on the copper surface while the corrosion of copper is suppressed.

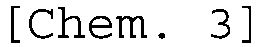

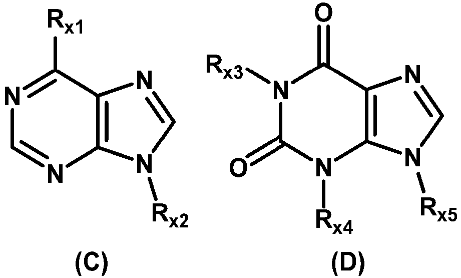

In formulas (C) and (D), Rₓ₁ to Rₓ₅ each independently represent a hydrogen atom, an alkyl group optionally having a substituent, an amino group optionally having a substituent, a thiol group, a hydroxy group, a halogen atom, a sugar group optionally having a substituent, or a polyoxyalkylene group-containing group optionally having a substituent.

In formula (C), Rₓ₁ and Rₓ₂ each independently represent a hydrogen atom, an alkyl group optionally having a substituent, an amino group optionally having a substituent, a thiol group, a hydroxy group, a halogen atom, a sugar group optionally having a substituent, or a polyoxyalkylene group-containing group optionally having a substituent.

The alkyl group may be linear, branched, or cyclic.

The number of carbon atoms in the alkyl group is preferably 1 to 10, more preferably 1 to 5, and still more preferably 1 to 3.

Examples of the sugar group include a group formed by removing one hydroxy group from a group selected from the group consisting of monosaccharides, disaccharides, and polysaccharides, and the sugar group is preferably a group formed by removing one hydroxy group from a monosaccharide.

Examples of the monosaccharide include: pentoses such as ribose, deoxyribose, arabinose, and xylose; trioses; tetroses; hexoses; and heptoses. The monosaccharide is preferably a pentose, more preferably ribose, deoxyribose, arabinose, or xylose, and still more preferably ribose or deoxyribose.

Examples of the disaccharide include sucrose, lactose, maltose, trehalose, turanose, and cellobiose.

Examples of the polysaccharide include glycogen, starch, and cellulose.

The saccharide may be a chain saccharide or a cyclic saccharide and is preferably a cyclic saccharide.

Examples of the cyclic saccharide include a furanose ring and a pyranose ring.

The polyoxyalkylene group-containing group optionally having a substituent means a polyoxyalkylene group-containing group optionally having a substituent in a part thereof.

Examples of the polyoxyalkylene group included in the polyoxyalkylene group-containing group include a polyoxyethylene group, a polyoxypropylene group, and a polyoxybutylene group, and a polyoxyethylene group is preferred.

Examples of the substituent that the alkyl group, the amino group, the sugar group, and the polyoxyalkylene group-containing group may have include: hydrocarbon groups such as optionally substituted alkyl groups, aryl groups, and a benzyl group; halogen atoms such as a fluorine atom, a chlorine atom, and a bromine atom; alkoxy groups; a hydroxy group; alkoxycarbonyl groups such as a methoxycarbonyl group and an ethoxycarbonyl group; acyl groups such as an acetyl group, a propionyl group, and a benzoyl group; a cyano group; and a nitro group.

Examples of the substituent that the optionally substituted alkyl group may have include those exemplified for the above substituent, and more preferred examples thereof include aryl groups and heteroaryl groups.

Rₓ₁ is preferably a hydrogen atom or an amino group optionally having a substituent and more preferably an amino group optionally having a substituent. Another preferred mode of Rₓ₁ is an alkyl group optionally having a substituent, a thiol group, a hydroxy group, a halogen atom, a sugar group optionally having a substituent, or a polyoxyalkylene group-containing group optionally having a substituent.

Rₓ₂ is preferably a hydrogen atom, an alkyl group optionally having a substituent, or a sugar group optionally having a substituent, more preferably a hydrogen atom or a sugar group optionally having a substituent, and still more preferably a hydrogen atom.

In formula (D), Rₓ₃ to Rₓ₅ each independently represent a hydrogen atom, an alkyl group optionally having a substituent, an amino group optionally having a substituent, a thiol group, a hydroxy group, a halogen atom, a sugar group optionally having a substituent, or a polyoxyalkylene group-containing group optionally having a substituent.

Examples of the modes of the groups represented by Rₓ₃ to Rₓ₅ include those of the groups represented by Rₓ₁ and Rₓ₂ in formula (C).

Rₓ₃ is preferably a hydrogen atom or an alkyl group optionally having a substituent and more preferably an alkyl group optionally having a substituent.

Another preferred mode of Rₓ₃ is an alkyl group optionally having a substituent, an amino group optionally having a substituent, a thiol group, a hydroxy group, a halogen atom, a sugar group optionally having a substituent, or a polyoxyalkylene group-containing group optionally having a substituent.

Rₓ₄ is preferably a hydrogen atom or an alkyl group optionally having a substituent and more preferably an alkyl group optionally having a substituent.

Rₓ₅ is preferably a hydrogen atom or an alkyl group optionally having a substituent.

In particular, it is preferable that the corrosion inhibitor includes at least one selected from the group consisting of purine, adenine, xanthine, theobromine, caffeine, adenosine, 6-benzyladenine, kinetin, dimethyladenine, methyladenine, enprofylline, xanthosine, 7-methylxanthosine, 7-methylxanthine, theophylline, eritadenine, paraxanthine, 3-methylxanthine, 1,7-dimethylxanthine, 1-methylxanthine, pyrazole, imidazole, 3-amino-5-tert-butyl-1H-pyrazole, 5-amino-1H-tetrazole, and 4-methylpyrazole, and it is more preferable that the corrosion inhibitor includes at least one selected from the group consisting of adenine, xanthine, adenosine , 6-benzyladenine, kinetin, dimethyladenine, methyladenine, pyrazole, imidazole, 3-amino-5-tert-butyl-1H-pyrazole, 5-amino-1H-tetrazole, and 4-methylpyrazole.

One corrosion inhibitor may be used alone, or a combination of two or more may be used.

The content of the corrosion inhibitor with respect to the total mass of the cleaning solution is preferably 0.00001 to 1.0% by mass, more preferably 0.0001 to 0.1% by mass, and still more preferably 0.0001 to 0.01% by mass.

The mass ratio of the amount of the corrosion inhibitor with respect to the total amount of the solids in the cleaning solution is preferably 0.0001 to 1.0, more preferably 0.001 to 1.0, and still more preferably 0.001 to 0.1.

### [Water]

Preferably, the cleaning solution of the invention includes water as a solvent because the effects of the invention are further enhanced.

Any type of water may be used for the cleaning solution so long as the semiconductor substrate is not adversely affected, and distilled water, deionized water (DI water), and pure water (ultrapure water) can be used. Pure water (ultrapure water) is preferred because it contains almost no impurities and its influences on a semiconductor substrate in its production process are smaller.

The content of water with respect to the total mass of the cleaning solution is preferably 1.0% by mass or more, more preferably 30.0% by mass or more, still more preferably 60.0% by mass or more, and particularly preferably 80.0% by mass or more. The upper limit of the content of water with respect to the total mass of the cleaning solution is preferably 99.999% by mass or less, more preferably 99.99% by mass or less, and still more preferably 98.0% by mass or less.

### [Low-molecular weight organic acid]

The cleaning solution of the invention may include a low-molecular weight organic acid. The low-molecular weight organic acid is a compound that differs from the specific polymer in that it has no repeating unit.

The molecular weight of the low-molecular weight organic acid is preferably 600 or less, more preferably 450 or less, and still more preferably 300 or less. The lower limit of the molecular weight is preferably 50 or more and more preferably 100 or more.

The number of carbon atoms in the organic acid is preferably 1 to 15 and more preferably 2 to 15.

The low-molecular weight organic acid is preferably a carboxylic acid-based organic acid. The carboxylic acid-based organic acid means an organic acid having at least one carboxy group in its molecule.

Examples of the carboxylic acid-based organic acid include amino polycarboxylic acid-based organic acids, amino acid-based organic acids, and aliphatic carboxylic acid-based organic acids. The carboxylic acid-based organic acid is preferably an aliphatic carboxylic acid-based organic acid.

Examples of the amino polycarboxylic acid-based organic acid include 1,4-butanediaminetetraacetic acid (BDTA), diethylenetriaminepentaacetic acid (DTPA), ethylenediaminetetrapropionic acid, triethylenetetraminehexaacetic acid, 1,3-diamino-2-hydroxypropane-N,N,N',N'-tetraacetic acid, 1,3-propanediamine-N,N,N',N'-tetraacetic acid, ethylenediaminetetraacetic acid (EDTA), trans-1,2-diaminocyclohexanetetraacetic acid, ethylenediaminediacetic acid, ethylenediaminedipropionic acid, 1,6-hexamethylenediamine-N,N,N',N'-tetraacetic acid, N,N-bis(2-hydroxybenzyl)ethylenediamine-N,N-diacetic acid, diaminopropanetetraacetic acid, 1,4,7,10-tetraazacyclododecane-tetraacetic acid, diaminopropanoltetraacetic acid, (hydroxyethyl)ethylenediaminetriacetic acid, and iminodiacetic acid (IDA).

Examples of the amino acid-based organic acid include glycine, serine, α-alanine (2-aminopropionic acid), β-alanine (3-aminopropionic acid), lysine, leucine, isoleucine, cystine, cysteine, ethionine, threonine, tryptophan, tyrosine, valine, histidine, histidine derivatives, asparagine, aspartic acid, glutamine, glutamic acid, arginine, proline, methionine, phenylalanine, compounds described in paragraphs [0021] to [0023] of JP2016-086094A, and salts thereof.

Examples of the histidine derivatives include compounds described in JP2015-165561A and JP2015-165562A, and the contents thereof are incorporated in the present specification. Examples of the salts include alkali metal salts such as sodium salts and potassium salts, ammonium salts, carbonates, and acetates.

The aliphatic carboxylic acid-based organic acid may have a hydroxy group in addition to the carboxy group and the aliphatic group.

Examples of the aliphatic carboxylic acid-based organic acid include tartaric acid, oxalic acid, malonic acid, succinic acid, glutaric acid, gluconic acid, adipic acid, pimelic acid, sebacic acid, maleic acid, malic acid, and citric acid.

### <Phosphonic acid-based organic acid>

A phosphonic acid-based organic acid is an organic acid having at least one phosphonic acid group in its molecule.

An organic acid having a phosphonic acid group and a carboxy group is classified as a carboxylic acid-based organic acid.

Examples of the phosphonic acid-based organic acid include aliphatic phosphonic acid-based organic acids and amino phosphonic acid-based organic acids.

The aliphatic phosphonic acid-based organic acid may have a hydroxy group in addition to the phosphonic acid group and the aliphatic group.

Examples of the phosphonic acid-based organic acid include ethylidenediphosphonic acid, 1-hydroxyethylidene-1,1'-diphosphonic acid (HEDPO), 1-hydroxypropylidene-1,1'-diphosphonic acid, 1-hydroxybutylidene-1,1'-diphosphonic acid, ethylaminobis(methylenephosphonic acid), dodecylaminobis(methylenephosphonic acid), nitrilotris(methylenephosphonic acid) (NTPO), ethylenediaminebis(methylenephosphonic acid) (EDDPO), 1,3-propylenediaminebis(methylenephosphonic acid), ethylenediaminetetra(methylenephosphonic acid) (EDTPO), ethylenediaminetetra(ethylenephosphonic acid), 1,3-propylenediaminetetra(methylenephosphonic acid) (PDTMP), 1,2-diaminopropanetetra(methylenephosphonic acid), 1,6-hexamethylenediaminetetra(methylenephosphonic acid), diethylenetriaminepenta(methylenephosphonic acid) (DEPPO), diethylenetriaminepenta(ethylenephosphonic acid), triethylenetetraminehexa(methylenephosphonic acid), and triethylenetetraminehexa(ethylenephosphonic acid). The phosphonic acid-based organic acid is preferably HEDPO or EDTPO.

The low-molecular weight organic acid is preferably a carboxylic acid-based organic acid, more preferably an aliphatic carboxylic acid-based organic acid, and still more preferably tartaric acid, malonic acid, succinic acid, malic acid, or citric acid.

One low-molecular weight organic acid may be used alone, or a combination of two or more may be used.

The content of the low-molecular weight organic acid with respect to the total mass of the cleaning solution is preferably 0.00001 to 10% by mass, more preferably 0.0003 to 1% by mass, and still more preferably 0.0005 to 0.1% by mass.

The mass ratio of the amount of the low-molecular weight organic acid with respect to the total amount of the solids in the cleaning solution is preferably 0.01 to 90.0% by mass, more preferably 0.1 to 55.0% by mass, and still more preferably 1.0 to 20.0% by mass.

The mass ratio of the amount of the corrosion inhibitor with respect to the amount of the low-molecular weight organic acid is preferably 0.001 to 10.0, more preferably 0.01 to 5.0, and still more preferably 0.1 to 1.0.

### [pH modifier]

The cleaning solution of the invention may include a pH modifier in order to adjust and maintain the pH of the cleaning solution of the invention.

The pH modifier is a basic compound or an acidic compound different from the above-described compositions included in the cleaning solution of the invention. However, the pH of the cleaning solution of the invention may be adjusted by adjusting the amounts of the components included in the cleaning solution of the invention.

The basic compound is a compound that exhibits basicity (a pH of more than 7.0) in an aqueous solution. Examples of the basic compound include basic inorganic compounds and basic organic compounds.

Examples of the basic inorganic compounds include: ammonia; alkali metal hydroxides such as sodium hydroxide and potassium hydroxide; and alkaline earth metal hydroxides.

Examples of the basic organic compounds include: quaternary ammonium compounds other than ammonia; and amine compounds such as trishydroxymethylaminomethane.

### <Quaternary ammonium compound>

The basic compound used as the pH modifier is preferably the quaternary ammonium compound.

The quaternary ammonium compound may be a quaternary ammonium cation (ammonia) having no hydrocarbon group but is preferably a compound having a quaternary ammonium cation obtained by adding four hydrocarbon groups (preferably alkyl groups) to a nitrogen atom by substitution. The quaternary ammonium compound may be a compound, such as alkylpyridinium, having a quaternary ammonium cation including a pyridine ring in which the nitrogen atom is bonded to a substituent (a hydrocarbon group such as an alkyl group or an aryl group).

Examples of the quaternary ammonium compound include quaternary ammonium hydroxides, quaternary ammonium fluorides, quaternary ammonium bromides, quaternary ammonium iodides, quaternary ammonium acetates, and quaternary ammonium carbonates.

Examples of the quaternary ammonium compound include ammonia, ammonium fluoride, tris(2-hydroxyethyl)methylammonium hydroxide (THEMAH), dimethylbis(2-hydroxyethyl)ammonium hydroxide, tetramethylammonium hydroxide (TMAH), ethyltrimethylammonium hydroxide (ETMAH), trimethylethylammonium hydroxide (TMEAH), dimethyldiethylammonium hydroxide (DMDEAH), methyltriethylammonium hydroxide (MTEAH), tetraethylammonium hydroxide (TEAH), tetrapropylammonium hydroxide (TPAH), tetrabutylammonium hydroxide (TBAH), 2-hydroxyethyltrimethylammonium hydroxide (choline), bis(2-hydroxyethyl)dimethylammonium hydroxide, tri(2-hydroxyethyl)methylammonium hydroxide, tetra(2-hydroxyethyl)ammonium hydroxide, benzyltrimethylammonium hydroxide (BTMAH), and cetyltrimethylammonium hydroxide. The quaternary ammonium compound is preferably Tris, choline, or ETMAH.

The acidic compound used as the pH modifier is a compound that exhibits acidity (a pH of less than 7.0) in an aqueous solution, and examples thereof include acidic inorganic compounds.

Examples of the acidic inorganic compounds include hydrochloric acid, nitric acid, nitrous acid, sulfurous acid, phosphoric acid, boric acid, carbonic acid, hypophosphorous acid, phosphorous acid, and hexafluorophosphoric acid.

The acidic compound used as the pH modifier may be a salt of an acidic compound so long as it forms an acid or an acid ion (anion) in an aqueous solution.

The content of the pH modifier may be selected according to the types and amounts of other components and the target pH of the cleaning solution. For example, the content of the pH modifier with respect to the total mass of the cleaning solution is preferably 0.0001 to 10% by mass, more preferably 0.001 to 8% by mass, and still more preferably 0.01 to 5% by mass.

### [Additional components]

The cleaning solution of the invention may further include additional components other than the components described above. Examples of the additional components include an organic solvent, a preservative (antimicrobial agent), a reducing agent, and dissolved gas.

The additional components will next be described.

### <Organic solvent>

The cleaning solution of the invention may include an organic solvent. The organic solvent may be a well-known organic solvent, and examples thereof include alcohol-based solvents, glycol-based solvents, glycol ether-based solvents, and ketone-based solvents.

It is preferable that the organic solvent is miscible with water in any ratio.

Examples of the organic solvent include compounds shown in paragraphs [0135] to [140] of WO2022/044893A, and the contents thereof are incorporated in the present specification.

### <Preservative>

The cleaning solution of the invention may include a preservative.

The preservative is a compound different from the above-described components included in the cleaning solution of the invention.

Examples of the preservative include benzoic acid, sodium benzoate, salicylic acid, propionic acid, isopropyl parahydroxybenzoate, isobutyl parahydroxybenzoate, ethyl parahydroxybenzoate, methyl parahydroxybenzoate, butyl parahydroxybenzoate, propyl parahydroxybenzoate, sodium sulfite, sodium hyposulfite, potassium pyrosulfite, sorbic acid, potassium sorbate, sodium dehydroacetate, thujaplicin, udo extract, storax extract, Artemisia capillaris extract, oolong tea extract, milt protein extract, enzymatically hydrolyzed coix extract, tea catechins, apple polyphenols, pectin digests, chitosan, lysozyme, and ε-polylysine.

In particular, the preservative is preferably benzoic acid, sorbic acid, salicylic acid, or propionic acid.

The content of the preservative with respect to the total mass of the cleaning solution is preferably 0.0001 to 10.0% by mass, more preferably 0.0001 to 1.0% by mass, and still more preferably 0.0001 to 0.1% by mass.

### <Reducing agent>

The cleaning solution of the invention may include a reducing agent.

The reducing agent is a compound having an reducing action and having the function of reducing OH⁻ ions or dissolved oxygen included in the cleaning solution and is referred to also as a deoxidizer. The reducing agent improves the corrosion protection ability of the cleaning solution.

No particular limitation is imposed on the reducing agent used in the cleaning solution. Examples of the reducing agent include ascorbic acid compounds, catechol compounds, hydroxylamine compounds, hydrazide compounds, and reductive sulfur compounds.

Specific examples of the ascorbic acid compounds, the catechol compounds, the hydroxylamine compounds, the hydrazide compounds, and the reductive sulfur compounds include compounds described in paragraphs [0084] to [0093] of WO2021/131452A, and the contents thereof are incorporated in the present specification.

### <Dissolved gas>

The cleaning solution of the invention may include dissolved gas. By adjusting the concentration of the dissolved gas in the cleaning solution within an appropriate range, the ability to remove residues (cleaning ability) can be improved.

The concentration of the dissolved gas with respect to the total volume of the cleaning solution of the invention is preferably 0.01 to 10 mg/L.

The concentration of the dissolved gas with respect to the total volume of the cleaning solution of the invention is preferably 0.05 mg/L or more and more preferably 0.1 mg/L or more because the effect of removing residues is further enhanced. The concentration of the dissolved gas with respect to the total volume of the cleaning solution of the invention is preferably 7 mg/L or less, more preferably 4 mg/L or less, and still more preferably 1.5 mg/L or less because the storage stability is further improved.

No particular limitation is imposed on the dissolved gas, but the dissolved gas is preferably clean air. In the present specification, the "clean air" refers to air classified as Class 8 or lower (Class 8 or lower class) in ISO standards ISO 14644-1:2015.

The concentration of the dissolved gas in a surface-treated composition can be evaluated by measuring the concentration of oxygen gas (O₂ gas), the concentration of nitrogen gas (N₂ gas), and the concentration of carbon dioxide gas (CO₂ gas) and then determining the total. As the method for measuring the oxygen gas, nitrogen gas, and carbon dioxide gas, a processing method described in paragraph [0020] of WO2020/194978A can be used, and the contents thereof are incorporated in the present specification.

The concentration of the dissolved gas can be controlled by a well-known method. For example, a method described in paragraphs [0019], [0052] to [0056], and [0060] to [0062] of WO2020/194978A can be used for reference, and the contents thereof are incorporated in the present specification.

### <Abrasive particles>

Preferably, the cleaning solution includes substantially no abrasive particles.

The abrasive particles are particles included in a polishing liquid used for polishing treatment for a semiconductor substrate and are particles having an average primary particle diameter of 5 nm or more.

Examples of the abrasive particles include: particles of inorganic solid materials such as silica (including colloidal silica and fumed silica), alumina, zirconia, ceria, titania, germania, manganese oxide, and silicon carbide; particles of organic solid materials such as polystyrene, polyacrylic resins, and polyvinyl chloride.

The phrase "includes substantially no abrasive particles" means that the content of the abrasive particles with respect to the total mass of the cleaning solution is less than 0.1% by mass. The content of the abrasive particles is preferably 0.01% by mass or less and more preferably 0.001% by mass or less. No particular limitation is imposed on the lower limit of the content, and the lower limit is 0% by mass.

The content of the abrasive particles can be measured using a commercial measurement device for a light scattering-type liquid-borne particle measurement method using a laser as a light source.

The average primary particle diameter of particles such as abrasive particles is determined by measuring the particle diameters (equivalent circle diameters) of 1000 primary particles arbitrary selected in an image obtained using a transmission electron microscope TEM 2010 (acceleration voltage: 200 kV) manufactured by JEOL Ltd. and then determining the arithmetic average of the measured particle diameters. The equivalent circle diameter of a particle is the diameter of a perfect circle that has the same projected area as the projected area of the particle at the time of observation.

Examples of a method for removing abrasive particles from the cleaning solution include refining treatment such as filtering.

### [Physical properties of cleaning solution]

### <pH>

No particular limitation is imposed on the pH of the cleaning solution so long as it is 7.5 or more. The pH of the cleaning solution is preferably 9.0 or more, more preferably 10.0 or more, and still more preferably 11.0 or more. No particular limitation is imposed on the upper limit of the pH, but the upper limit may be 14.0.

When the pH is within the above range, the organic residues (aggregates) described above can be easily dissolved in the cleaning solution.

The pH of the cleaning solution can be measured by a method using a well-known pH meter according to JIS Z 8802-1984. The temperature during the pH measurement is 25°C.

### <Contents of metals>

The contents (measured as ion concentrations) of metals (metal elements such as Fe, Co, Na, Cu, Mg, Mn, Li, Al, Cr, Ni, Zn, Sn, and Ag) included as impurities in the cleaning solution are each preferably 5 ppm by mass or less and more preferably 1 ppm by mass or less. In particular, the content of sodium atoms in the cleaning solution with respect to the total mass of the cleaning solution is preferably 1 ppm by mass or less.

In the manufacture of most advanced semiconductor elements, it is expected that a cleaning solution with higher purity will be required. Therefore, the content of each metal is more preferably lower than 1 ppm by mass, i.e., a value on the order of ppb by mass, particularly preferably 100 ppb by mass or less, and most preferably less than 10 ppb by mass. The lower limit of the content is preferably 0.

Examples of a method for reducing the metal contents include refining treatment such as distillation or filtration using an ion-exchanged resin or a filter at the stage of preparing raw materials used to manufacture the cleaning solution or at the stage after the manufacture of the cleaning solution.

Other examples of the method for reducing the metal contents include the use of a container described later that is less susceptible to dissolution of impurities as a container for housing the raw materials or the manufactured cleaning solution. Alternatively, a fluorocarbon resin lining may be formed on the inner wall of a pipe etc. used to manufacture the cleaning solution so that metal components are prevented from dissolving from the pipe during the manufacture of the cleaning solution.

### <Insoluble particles>

Preferably, the cleaning solution includes substantially no insoluble particles.

The "insoluble particles" correspond to particles of inorganic solid materials and organic solid materials that do not dissolve in the cleaning solution and are finally present as particles.

The phrase "includes substantially no insoluble particles" means that, when the cleaning solution is diluted 10000-fold with a solvent contained in the cleaning solution to prepare a composition for measurement, the number of particles having a diameter of 40 nm or more in 1 mL of the composition for measurement is 40000 or less. The number of particles included in the composition for measurement can be measured using a commercial particle counter.

The commercial particle counter used may be an apparatus manufactured by RION Co., Ltd. or an apparatus manufactured by PMS. Representative examples of the former apparatus include KS-19F, and representative examples of the latter apparatus include UltraChem 40. To measure coarser particles, apparatuses such as the KS-42 series and the LiQuilaz II S series can be used.

Examples of the insoluble particles include: particles of inorganic solid materials such as silica (including colloidal silica and fumed silica), alumina, zirconia, ceria, titania, germania, manganese oxide, and silicon carbide; and particles of organic solid materials such as polystyrene, polyacrylic resins, and polyvinyl chloride.

Examples of a method for removing insoluble particles from the cleaning solution include refining treatment such as filtering.

### <Coarse particles>

The cleaning solution may include coarse particles. However, the smaller the content of the coarse particles, the better.

The coarse particles are particles having a diameter (particle diameter) of 1 µm or more when the particles are assumed to be spherical in shape.

The coarse particles included in the cleaning solution are particles of dust, dirt, organic solid materials, and inorganic solid materials that are included as impurities in the raw materials and particles of dust, dirt, organic solid materials, and inorganic solid materials that are introduced as contaminants during preparation of the cleaning solution. These materials do not dissolve in the cleaning solution and are finally present as particles.

As for the content of the coarse particles in the cleaning solution, the content of particles having a particle diameter of 1 µm or more in 1 mL of the cleaning solution is preferably 100 or less and more preferably 50 or less. The lower limit of the content in 1 mL of the cleaning solution is preferably 0 or more and more preferably 0.01 or more.

The content of the coarse particles present in the cleaning solution can be measured in a liquid phase using a commercial measurement device for a light scattering-type liquid-borne particle measurement method using a laser as a light source.

Examples of a method for removing the coarse particles include refining treatment such as filtering.

### [Method for manufacturing cleaning solution]

The cleaning solution can be manufactured by a well-known method. The method for manufacturing the cleaning solution will next be described in detail.

### [Preparation step]

The cleaning solution can be manufactured, for example, by mixing the components described above.

In one example of the method for preparing the cleaning solution, a container containing purified pure water is successively charged with the compound represented by formula (A), the specific polymer, and optional components added as necessary, and these components are stirred and mixed. Then a pH modifier is optionally added to adjust the pH of the mixture to thereby prepare the cleaning solution. When the components are added to the container, they may be added all at once or separately in portions.

As for the stirring device and the stirring method used to prepare the cleaning solution, a well-known stirrer or disperser may be used. Examples of the stirrer include industrial mixers, portable stirrers, mechanical stirrers, and magnetic stirrers. Examples of the disperser include industrial dispersers, homogenizers, ultrasonic dispersers, and bead mills.

The mixing of the components and refining treatment described later in the step of preparing the cleaning solution are performed at preferably 40°C or lower and more preferably 30°C or lower, and the manufactured cleaning solution is stored at preferably 40°C or lower and more preferably 30°C or lower. The lower limit of the temperature is preferably 5°C or higher and more preferably 10°C or higher. When the temperature at which the cleaning solution is prepared, the temperature at which the treatment is performed, and/or the storage temperature is within the above range, the performance can be stably maintained for a long time.

### <Refinement>

Preferably, at least one of the raw materials used to prepare the cleaning solution is subjected to refining treatment in advance. Examples of the refining treatment include well-known methods such as distillation, ion exchange, and filtration (filtering).

As for the degree of refinement, it is preferable that the raw material is refined to a purity of 99% by mass or more, and it is more preferable that the raw material is refined to a purity of 99.9% by mass or more. The upper limit of the purity is preferably 99.9999% by mass or less.

Examples of the method for the refining treatment include a method in which the raw material is caused to pass through an ion exchanged resin or an RO membrane (reverse osmosis membrane), reprecipitation, distillation of the raw material, and filtering.

In the refining treatment, a plurality of methods selected from the above refining methods may be used in combination. For example, the raw material may be subjected to primary refinement in which the raw material is caused to pass through an RO membrane and then subjected to secondary refinement in which the resulting raw material is caused to pass through a refinement device including a cation exchange resin, an anion exchange resin, or a mix bed ion exchange resin.

The refining treatment may be performed a plurality of times.

No particular limitation is imposed on the filter used for the filtering, so long as it is a filter that has been used for filtration and other similar applications. Examples of the filter include filters formed of fluorocarbon resins such as polytetrafluoroethylene (PTFE) and tetrafluoroethylene perfluoroalkyl vinyl ether copolymers (PFA), polyamide-based resins such as nylons, polyallyl sulfone (PAS), and polyolefin resins such as polyethylene and polypropylene (PP) (including high-density and ultrahigh molecular weight resins). Of these materials, a material selected from the group consisting of polyethylene, polypropylene (including high-density polypropylene), fluorocarbon resins (including PTFE and PFA), and polyamide-based resins (including nylons) is preferred, and a fluorocarbon resin filter is more preferred. By filtering the raw material using a filter formed of any of these materials, highly-polar foreign substances that are likely to cause defects can be effectively removed.

### <Container>

The cleaning solution (including a diluted cleaning solution described later) can be charged into any container, and the cleaning solution in the container can be stored, transported, and used, so long as problems such as corrosion of the container do not occur.

The container is preferably a container with high cleanliness that is used for semiconductor applications and in which dissolution of impurities from the inner wall of a container portion of the container is reduced. Various containers commercially available as containers for semiconductor cleaning solutions may be used, and examples of such containers include, but not limited to, the "Clean Bottle" series manufactured by AICELLO CHEMICAL CO., LTD. and "Pure bottles" manufactured by KODAMA PLASTICS Co., Ltd.

The container may be any of those exemplified in paragraphs [0121] to [0124] of WO2022/004217A, and the contents thereof are incorporated in the present specification.

Preferably, the interior of the container is washed before charged with the cleaning solution. Preferably, the amount of metallic impurities contained in the liquid used for washing has been reduced. After the manufacturing, the cleaning solution may be bottled in a container such as a gallon bottle or a quart bottle, and the bottled cleaning solution may be transported and stored.

For the purpose of preventing deterioration of the components in the cleaning solution during storage, the interior of the container may be purged with an inert gas (such as nitrogen or argon) with a purity of 99.99995% by volume or higher. A gas with a small moisture content is particularly preferred. The container may be transported and stored at room temperature, or the temperature may be controlled within the range of -20°C to 20°C in order to prevent deterioration.

### <Clean room>

Preferably, the manufacture of the cleaning solution, unsealing and washing of the container, handling of the cleaning solution including charging of the cleaning solution etc., treatment and analysis, and measurement are all performed in a clean room. Preferably, the clean room meets the 14644-1 clean room standards. The clean room meets preferably one of ISO (International Organization for Standardization) Class 1, ISO Class 2, ISO Class 3, or ISO Class 4, more preferably ISO Class 1 or ISO Class 2, and still more preferably ISO Class 1.

### [Diluting step]

A diluting step is the step of diluting a concentrated solution with a diluent. The cleaning solution may be subjected to the diluting step to prepare a diluted cleaning solution (thinned cleaning solution), and the diluted cleaning solution may be used for the treatment of a target object. Specifically, the cleaning solution may be diluted with a diluent including water before use.

The concentrated solution and the diluted cleaning solution are both modes of the cleaning solution of the invention so long as they meet the requirements of the invention.

Preferably, the diluent used in the diluting step is subjected to refining treatment in advance. More preferably, the diluted cleaning solution obtained through the diluting step is subjected to refining treatment.

Examples of the refining treatment include: ionic component reduction treatment using an ion exchange resin, an RO membrane, etc. and described as the refining treatment for the cleaning solution; and removal of foreign substances by filtering. It is preferable to perform any of them.

The dilution ratio of the cleaning solution in the diluting step may be appropriately adjusted according to the types of components, the contents of the components, and the target object to be treated. However, the ratio of the diluted cleaning solution to the undiluted cleaning solution (the dilution factor) is preferably 10 to 10000, more preferably 10 to 1000, and still more preferably 10 to 300 in terms of mass ratio or volume ratio (volume ratio at 23°C).

It is preferable that the diluent includes water, and it is more preferable that the diluent is water, because the ability to remove residues is higher.

The change in the pH before and after the dilution (the difference between the pH of the undiluted cleaning solution and the pH of the diluted cleaning solution) is preferably 2.0 or less, more preferably 1.8 or less, and still more preferably 1.5 or less.

It is preferable that the pH of the undiluted cleaning solution and the pH of the diluted cleaning solution are both within the preferred range described above.

As for a specific method for the diluting step of diluting the cleaning solution, the diluting step may be performed according to the preparation step for the cleaning solution. As for the stirring device and the stirring method used in the diluting step, any of the well-known stirring devices exemplified for the preparation step for the cleaning solution may be used.

### [Application of cleaning solution]

Preferably, the cleaning solution of the invention is used to clean a target object subjected to chemical mechanical polishing (CMP) processing.

When the cleaning solution is used, the cleaning solution used may be diluted, as described above.

<Target object>

Examples of the target object for the cleaning solution include target objects including metal and semiconductor substrates including metal.

In a semiconductor substrate including metal, the metal may be present on any of the front and back sides of the semiconductor substrate and its side surfaces and in grooves, etc. In the semiconductor substrate including metal, the metal may be present directly on the surface of the semiconductor substrate, and also the metal may be present with another layer between the semiconductor substrate and the metal.

The metal is, for example, at least one metal M selected from the group consisting of copper (Cu), cobalt (Co), ruthenium (Ru), aluminum (Al), tungsten (W), titanium (Ti), tantalum (Ta), chromium (Cr), hafnium (Hf), osmium (Os), platinum (Pt), nickel (Ni), manganese (Mn), iron (Fe), zirconium (Zr), molybdenum (Mo), palladium (Pd), lanthanum (La), and iridium (Ir) and is preferably Cu, Co, or Ru and more preferably Cu or Co. Specifically, the target object is preferably a target object including at least one metal selected from the group consisting of Cu and Co.

The metal may be a material including a metal (metal atoms) and is, for example, a single metal M or an alloy including the metal M.

The target object for the cleaning solution may include, for example, a semiconductor substrate, a metal wiring film, a barrier metal, and an insulating film.

Examples of a wafer forming the semiconductor substrate include: wafers formed of silicon-based materials such as silicon (Si) wafers, silicon carbide (SiC) wafers, and silicon-containing resin-based wafers (glass epoxy wafers); gallium nitride (GaN) and gallium phosphide (GaP) wafers; gallium arsenide (GaAs) wafers; and indium phosphide (InP) wafers.

Examples of the silicon wafers include n-type silicon wafers obtained by doping silicon wafers with pentavalent atoms (such as phosphorus (P), arsenic (As), or antimony (Sb)) and p-type silicon wafers obtained by doping silicon wafers with trivalent atoms (such as boron (B) or gallium (Ga)). Examples of the silicon in the silicon wafer include amorphous silicon, single crystal silicon, polycrystalline silicon, and polysilicon.

In particular, a wafer formed of a silicon-based material such as a silicon wafer, a silicon carbide wafer, or a silicon-containing resin-based wafer (glass epoxy wafer) is preferred.

Examples of the insulating film include silicon dioxide (SiO₂) films and low-dielectric constant (Low-k) films having a lower dielectric constant than SiO₂.

Examples of the Low-k films include silicon oxide films (such as a tetraethyl orthosilicate (Si(OC₂H₅)₄) film (TEOS film)), silicon nitride films (such as a silicon nitride (Si₃N₄) film and a silicon carbonitride (SiCN) film), carbon-doped silicon oxide (SiOC) films, and silicon carbide (SiC) films.

The metal wiring film is preferably a copper-containing film, a cobalt-containing film, or a ruthenium-containing film.

Examples of the copper-containing film include wiring films composed only of metallic copper (copper wiring films) and alloy-made wiring films composed of metallic copper and another metal (copper alloy wiring films).

Examples of the copper alloy wiring films include alloy-made wiring films composed of copper and at least one metal selected from the group consisting of Al, Ti, Cr, Mn, Ta, and W.

More specific examples include copper-aluminum alloy wiring films (CuAl alloy wiring films), copper-titanium alloy wiring films (CuTi alloy wiring films), copper-chromium alloy wiring films (CuCr alloy wiring films), copper-manganese alloy wiring films (CuMn alloy wiring films), copper-tantalum alloy wiring films (CuTa alloy wiring films), and copper-tungsten alloy wiring films (CuW alloy wiring films).

Examples of the cobalt-containing film include metal films composed only of metallic cobalt (metallic cobalt films) and alloy-made metal films composed of metallic cobalt and another metal (cobalt alloy metal films).

Examples of the cobalt alloy metal films include alloy-made metal films composed of cobalt and at least one metal selected from the group consisting of Ti, Cr, Fe, Ni, Mo, Pd, Ta, and W. More specific examples include cobalt-titanium alloy metal films (CoTi alloy metal films), cobalt-chromium alloy metal films (CoCr alloy metal films), cobalt-iron alloy metal films (CoFe alloy metal films), cobalt-nickel alloy metal films (CoNi alloy metal films), cobalt-molybdenum alloy metal films (CoMo alloy metal films), cobalt-palladium alloy metal films (CoPd alloy metal films), cobalt-tantalum alloy metal films (CoTa alloy metal films), and cobalt-tungsten alloy metal films (CoW alloy metal films).

Examples of the ruthenium-containing films include metal films composed only of metallic ruthenium (ruthenium metal films) and alloy-made metal films composed of metallic ruthenium and another metal (ruthenium alloy metal films).

No particular limitation is imposed on the methods for forming, on the wafer forming the semiconductor substrate, the insulating film, the copper-containing film, the cobalt-containing film, and the ruthenium-containing film, so long as the methods are general methods performed in this field.

Examples of the method for forming the insulating film include a method including subjecting the wafer forming the semiconductor substrate to heat treatment in the presence of oxygen gas to form a silicon oxide film and then introducing silane and ammonia gas to form a silicon nitride film by the chemical vapor deposition (CVD) method.

Examples of the method for forming the copper-containing film, the cobalt-containing film, and the ruthenium-containing film include a method including forming a circuit on the wafer having the insulating film using a well-known method such as a resist and then forming the copper-containing film, the cobalt-containing film, and the ruthenium-containing film by plating or a method such as the CVD method.

The cleaning solution of the invention can be particularly preferably applied to a target object having a copper surface and a silicon carbonitride surface subjected to chemical mechanical polishing processing and used to clean the copper surface and the silicon carbonitride surface of the target object.

### <CMP processing>

The target object is a target object subjected to CMP processing (preferably a target object including a metal subjected to CMP processing).

The CMP processing is planarization processing performed on the surface of a semiconductor substrate including, for example, a metal wiring film, a barrier metal, and an insulating film through the combined action of chemical action and mechanical polishing using a polishing slurry including fine abrasive particles (abrasive grains).

### <Target object subjected to pad cleaning processing>

The surface of the target object may be subjected to pad cleaning processing after the CMP processing.

The pad cleaning processing is processing for reducing the amount of residues remaining on the surface of the processed portions using a pad. Specifically, the surface of the target object subjected to the CMP processing is brought into contact with the pad, and the target object and the pad are caused to slide against each other while a pad cleaning composition is supplied to the contact portion. In this manner, residues on the surface of the target object are removed through the frictional force of the pad and the chemical action of the pad cleaning composition.

No particular limitation is imposed on the pad, and the pad may be appropriately selected according to the type of target object, the type of residues to be removed, and the device used. The pad used may be a polishing pad used for CMP processing or may be a buff pad such as a foamed polyurethane-based buff pad, a nonwoven fabric, a suede-based buff pad, or a sponge. The pad cleaning processing using the pad includes processing called buff cleaning or buff polishing.

The pad cleaning composition used may be a well-known cleaning composition selected according to the type of target object and the type and amount of residues to be removed. Examples of the component included in the pad cleaning composition include ammonium fluoride (NH₄F), 1-hydroxyethylidene-1,1'-diphosphonic acid (HEDPO), watersoluble polymers such as polyvinyl alcohol, dispersion mediums such as water, and acids such as nitric acid. The pad cleaning composition includes no abrasive particles.

The device used in the pad cleaning processing and the conditions therefor can be appropriately selected from well-known devices and conditions according to the type of target object and the type and amount of residues to be removed. For example, a processing method described in paragraphs [0085] to [0088] of WO2017/169539A can be used, and the contents thereof are incorporated in the present specification.

In one preferred embodiment of the pad cleaning processing, the target object is subjected to the pad cleaning processing using the cleaning solution of the invention as the pad cleaning composition.

The cleaning solution used for the pad cleaning processing may be the diluted cleaning solution.

The pad cleaning processing may be performed only once or performed twice or more. For example, after the CMP processing, pad cleaning processing using a polishing pad and pad cleaning processing using a buff pad may be performed.

### [Method for cleaning target object]

No particular limitation is imposed on the target object cleaning method of the invention so long as the method is a processing method including the step (contact step) of bringing the target object into contact with the cleaning solution of the invention. In the present invention, the target object is a target object having a copper surface and a silicon carbonitride surface that have been subjected to chemical mechanical polishing processing in many cases.

With the processing method described above, for example, a semiconductor substrate subjected to CMP processing can be cleaned. Preferably, the semiconductor substrate cleaning method includes the step of cleaning the semiconductor substrate subjected to CMP processing using the diluted cleaning solution obtained through the diluting step.

No particular limitation is imposed on the method for bringing the target object into contact with the cleaning solution, and examples thereof include a method in which the target object is immersed in the cleaning solution placed in a tank, a method in which the cleaning solution is sprayed onto the target object, a method in which the cleaning solution is caused to flow onto the target object, and combinations thereof. Any of these methods may be appropriately selected according to the intended purpose.

A scheme commonly used in this field may be appropriately used for the above method. For example, scrub cleaning in which a cleaning member such as a brush is brought into physical contact with the target object while the cleaning solution is supplied to thereby remove residues etc. or a spinning (dropping) method in which the cleaning solution is dropped while the target object is rotated may be used. In the immersion method, it is preferable to subject the target object immersed in the cleaning solution to ultrasonic processing because the amount of impurities remaining on the surface of the target object can be further reduced.

The target object and the cleaning solution may be brought into contact with each other in the contact step only once or twice or more. When they are brought into contact with each other twice or more, the same method may be repeated, or a combination of different methods may be used.

A sheet-fed process or a batch process may be used for the method for the contact step.

The sheet-fed process is generally a process in which target objects are processed one by one, and the batch process is generally a process in which a plurality of target objects are processed at a time.

No particular limitation is imposed on the temperature of the cleaning solution so long as it is a temperature generally used in this field. The temperature is generally room temperature (about 25°C) but may be freely selected in order to improve the ability to remove residues and reduce damage to a member. The temperature of the cleaning solution is, for example, preferably 10 to 60°C and more preferably 15 to 50°C.

The time of contact between the target object and the cleaning solution may be appropriately changed according to the types and amounts of components included in the cleaning solution. Practically, the time of contact is preferably 10 seconds to 2 minutes, more preferably 20 seconds to 1 minute 30 seconds, and still more preferably 30 seconds to 1 minute.

The supply amount (supply rate) of the cleaning solution in the contact step is preferably 50 to 5000 mL/minute and more preferably 500 to 2000 mL/minute.

In the contact step, a mechanical stirring method may be used in order to enhance the ability of the cleaning solution to remove residues.

Examples of the mechanical stirring method include a method in which the cleaning solution is circulated on the semiconductor substrate, a method in which the cleaning solution is caused flow onto the semiconductor substrate or sprayed onto the semiconductor substrate, and a method in which the cleaning solution is ultrasonically or megasonically stirred.

After the contact step, the step of bringing the target object into contact with a rinsing solution (this step is hereinafter referred to as a "rinsing step") may be performed. By performing the rinsing step, the target object obtained through the contact step is washed with the rinsing solution, and the residues can be effectively removed.

Preferably, the rinsing step is performed continuously after the step of cleaning the target object and is the step of rinsing the target object with the rinsing solution. The rinsing step may be performed using the mechanical stirring method described above.

Examples of the rinsing solution include water (preferably deionized (DI: De-Ionized) water), methanol, ethanol, isopropyl alcohol, N-methylpyrrolidinone, γ-butyrolactone, dimethyl sulfoxide, ethyl lactate, and propylene glycol monomethyl ether acetate. An aqueous rinsing solution (such as a diluted aqueous ammonium hydroxide solution) having a pH of more than 8.0 may be used.

The above-described method for bringing the cleaning solution into contact with the target object can also be applied to a method for bringing the rinsing solution into contact with the target object.

The time of contact between the target object and the rinsing solution can be appropriately changed according to the types and contents of components included in the cleaning solution and the intended use and purpose of the cleaning solution. Practically, the time of contact is preferably 10 to 120 seconds, more preferably 20 to 90 seconds, and still more preferably 30 to 60 seconds.

After the rinsing step, a drying step of drying the target object may be performed.

Examples of a drying method include a spin drying method, a method in which a dry gas is caused to flow onto the semiconductor substrate, a method in which the substrate is heated using heating means such as a hot plate or an infrared lamp, a Marangoni drying method, a Rotagoni drying method, an IPA (isopropyl alcohol) drying method, and combinations of any of these method.

### [Method for manufacturing semiconductor device]

The above-described target object cleaning method can be preferably used for a method for manufacturing a semiconductor device.

The cleaning method may be performed in combination with another step performed on the substrate before or after the other step. The other step may be performed during the cleaning step, or the cleaning step may be performed during the other step.

Examples of the other step include the step of forming structures such as metal wiring, a gate structure, a source structure, a drain structure, an insulating film, a ferromagnetic layer, and a non-magnetic layer (such as layer formation, etching, chemical mechanical polishing, and reforming), the step of forming a resist, an exposure step, a removal step, a heat treatment step, a cleaning step, and an inspection step.

The above processing method may be performed during a back end process (BEOL: back end of the line), a middle process (MOL: middle of the line), or a front end process (FEOL: front end of the line) and is preferably performed during the front end process or the middle process.

### [EXAMPLES]

The present invention will be described in more detail based on Examples.

Materials, amounts used, ratios, processing details, processing procedures, etc. shown in the following Examples can be appropriately changed so long as they do not depart from the gist of the invention. Therefore, the scope of the present invention should not be construed as limited to the following Examples.

In the following Examples, the pH of the cleaning solution was measured at 25°C using a pH meter (type "F-74" manufactured by HORIBA Ltd.) according to JIS Z 8802-1984.

When the cleaning solutions in Examples and Comparative Examples were manufactured, the handling of containers, preparation of the cleaning solutions, charging with the cleaning solutions, storage of the cleaning solutions, analysis, and measurement were all performed in a clean room meeting the ISO class 2 or lower.

### [Raw materials of cleaning solutions]

To manufacture the cleaning solutions in the Examples and Comparative Examples, the following compounds were used. The components used in the Examples were all classified into a semiconductor grade or a high purity grade comparable thereto.

### [Compounds represented by formula (A)]

- EEDA: N-ethylethylenediamine
- Triethylamine
- MEDA: N-methylethylenediamine
- N,N-dimethylethylenediamine
- N,N'-dimethylethylenediamine
- 1-(2-Dimethylaminoethyl)-4-methylpiperazine
- 1-Methylpiperazine
- 2-Aminomethylpiperidine
- 1-Ethylpiperazine
- N-butylethylenediamine

### [Polymers]

- Polyethyleneimine
- Polyacrylic acid
- Acrylic acid-sulfonic acid copolymer (product name: ARON A-6012 (manufactured by TOAGOSEI Co., Ltd.))

The weight average molecular weights (Mw) of the above polymers are listed in a table shown later.

### [pH modifiers]

- ETMAH: Ethyltrimethylammonium hydroxide
- Choline
- THEMAH: Tris(2-hydroxyethyl)methylammonium hydroxide

### [Corrosion inhibitors]

- Adenine
- 6-Benzyladenine
- Adenosine
- Xanthine
- Benzotriazole
- 5-Methylbenzotriazole
- Pyrazole
- Imidazole
- 3-Amino-5-tert-butyl-1H-pyrazole
- 5-Amino-1H-tetrazole
- 4-Methylpyrazole

### [Additives]

- Citric acid
- Tartaric acid
- Malonic acid
- Succinic acid
- Malic acid

### [Additional component]

- Ultrapure water (manufactured by FUJIFILM Wako Pure Chemical Corporation)

### [Manufacture of cleaning solutions]

Next, a method for manufacturing the cleaning solutions in the Examples and Comparative Examples will be described using Example 1 as an example.

N-ethylethylenediamine, polyacrylic acid, ethyltrimethylammonium hydroxide, and adenine were added to ultrapure water such that the contents of the components satisfied the ratios shown in tables, and the resulting solution mixture was sufficiently stirred to thereby obtain an undiluted cleaning solution in Example 1 (a concentrated cleaning solution in Example 1). The content of the ultrapure water in the undiluted cleaning solution is the content of the remaining portion of the composition other than the components used to prepare the composition except for the ultrapure water.

The undiluted cleaning solution was diluted at a dilution factor (mass ratio) shown in a table to prepare the cleaning solution in Example 1.

The cleaning solutions in the Examples and Comparative Examples having compositions shown in the tables below were prepared according to the method for manufacturing the cleaning solution in Example 1.

### [Evaluation]

The following evaluation was performed using the cleaning solutions in the Examples and Comparative Examples manufactured by the above method.

### [Evaluation of cleaning ability (ability to remove organic residues)]

The ability to remove organic residues (the cleaning ability) when a semiconductor substrate subjected to chemical mechanical polishing was cleaned was evaluated.

FREX 300S-II (polishing device manufactured by EBARA CORPORATION) was used to polish a wafer (diameter: 12 inches) having a Cu (copper) film on its surface and a wafer (diameter: 12 inches) having a SiCN (silicon carbonitride) film on its surface using a polishing liquid 1 as the polishing liquid under the conditions of an average in-plane polishing pressure of 105 hPa, a polishing liquid supply rate of 200 mL/min, and a polishing time of 30 seconds.

Next, a polishing liquid 2 was used as the polishing liquid to further polish each of the wafers subjected to the above polishing treatment under the conditions of an average in-plane polishing pressure of 70 hPa, a polishing liquid supply rate of 200 mL/min, and a polishing time of 60 seconds.

Each wafer subjected to the CMP processing was subjected to scrab cleaning using a cleaning solution adjusted to room temperature (23°C) for 1 minute and then to drying treatment.

The composition of the polishing liquid 1 and the composition of the polishing liquid 2 are as follows. Polishing liquid 1 (pH 7.0)
- Colloidal silica (PL3, FUSO CHEMICAL CO., LTD.) 0.1% by mass
- Glycine 1.0% by mass
- 3-Amino-1,2,4-triazole 0.2% by mass
- 5-Methyl-benzotriazole 90 ppm by mass
- Hydrogen peroxide 1.0% by mass
- pH modifier (ammonia and nitric acid)
- Water Balance

### Polishing liquid 2 (pH 10.5)

- Colloidal silica (PL3, FUSO CHEMICAL CO., LTD.) 6.0% by mass
- Citric acid 1.0% by mass
- Alkyl alkoxylate surfactant 100 ppm by mass
- 5-Methyl-benzotriazole 0.3% by mass
- Hydrogen peroxide 1.0% by mass
- pH modifier (potassium hydroxide and nitric acid)
- Water Balance

Next, a defect detector (ComPlus-II manufactured by AMAT) was used to measure the number of detection signals with an intensity corresponding to a defect having a length of more than 0.1 µm on the polished surface of one of the wafers obtained.

Then each defect was observed under a scanning electron microscope (SEM), and constituent elements were optionally analyzed using an energy dispersive X-ray spectrometer (EDX) to identify the measurement target. In this manner, the number of defects was determined based on organic residues (residues including organic materials as main components) on the polished surface of the wafer.

The ability to clean the wafer having the Cu film and the ability to clean the wafer having the SiCN film were evaluated according to the following evaluation criteria. The A rating is most preferred, and the C rating or higher is practically preferred.

### (Evaluation criteria)

A: The number of organic residues per wafer is 20 or less.
B: The number of organic residues per wafer is more than 20 and 50 or less.
C: The number of organic residues per wafer is more than 50 and 80 or less.
D: The number of organic residues per wafer is more than 80.

### [Evaluation of corrosion inhibition ability]

2×2 cm copper coupon wafers were prepared, and the ability of a cleaning solution to inhibit corrosion of Cu was evaluated.

The wafers were immersed in the cleaning solutions at room temperature (25°C) for 30 minutes.

Then the content of Cu in each of the cleaning solutions after the immersion treatment was measured using an Agilent 8800 triple quadrupole ICP-MS (for semiconductor analysis, option #200) to determine the etching rate.

The cleaning solution was evaluated using the obtained etching rate according to the following evaluation criteria. The A rating is most preferred, and the C rating or higher is practically preferred.

### (Evaluation criteria)

A: The etching rate is less than 0.4 Å/min.
B: The etching rate is 0.4 Å/min or more and less than 0.6 Å/min.
C: The etching rate is 0.6 Å/min or more and less than 0.8 Å/min.
D: The etching rate is 0.8 Å/min or more.

### [Results]

The composition of each of the cleaning solutions used in the Examples and Comparative Examples and the results of the evaluation of each cleaning solution are shown in the tables.

In the tables, numerical values in the "Content (% by mass)" columns represent the contents (% by mass) of the respective components with respect to the total mass of an undiluted cleaning solution.

A numerical value in the "Dilution factor (mass ratio)" column represents the dilution factor when an undiluted cleaning solution is diluted to prepare a cleaning solution. For example, the value in Example 1 means that the undiluted cleaning solution was diluted 100-fold to prepare the cleaning solution.

A numerical value in the "pH after dilution" column represents the pH of a cleaning solution prepared in the "Manufacture of cleaning solutions" described above.

Numerical values in the "Class 1" and "Class 2" columns represent the classes of amine moieties in the compound represented by formula (A).

A numerical value in the "ClogP" column represents the ClogP value of the compound represented by formula (A). The ClogP value is a value obtained by drawing the structure using ChemDraw Professional (version 20.1.1) manufactured by PerkinElmer and computing the ClogP value using the above software.

Table 2 is continued from Table 1, and Table 3 is continued from Table 2. For example, in Example 1, an undiluted cleaning solution including 0.44% by mass of N-ethylethylenediamine, 0.36% by mass of polyacrylic acid, 1.74% by mass of ethyltrimethylammonium hydroxide, and 0.038% by mass of adenine was prepared and diluted 100-fold to prepare a cleaning solution, and the resulting cleaning solution was used for the evaluation. It was found that the ability to clean Cu, the ability to clean SiCN, and the corrosion inhibition ability were all rated A.

**[Table 1]**

| Table 1 | Cleaning solution for semiconductor substrate | | | | | | | |
|---|---|---|---|---|---|---|---|---|
| | Compound represented by formula (A) | | | | | Polymer | | |
| | Type | Class 1 | Class 2 | ClogP | Content (% by mass) | Type | Molecular weight (Mw) | Content (% by mass) |
| Comparative Example 1 | EEDA | 1 | 2 | -0.87 | 0.44 | Polyethyleneimine | 10000 | 0.36 |
| Comparative Example 2 | Triethylamine | 3 | - | 1.61 | 0.44 | Polyacrylic acid | 6000 | 0.36 |
| Comparative Example 3 | EEDA | 1 | 2 | -0.87 | 0.44 | - | - | - |
| Example 1 | EEDA | 1 | 2 | -0.87 | 0.44 | Polyacrylic acid | 6000 | 0.36 |
| Example 2 | MEDA | 1 | 2 | -1.40 | 0.37 | Polyacrylic acid | 6000 | 0.36 |
| Example 3 | N,N-dimethyl ethylenediamine | 1 | 3 | -0.32 | 0.44 | Polyacrylic acid | 6000 | 0.36 |
| Example 4 | EEDA | 1 | 2 | -0.87 | 0.44 | Polyacrylic acid | 6000 | 0.36 |
| Example 5 | EEDA | 1 | 2 | -0.87 | 0.44 | Polyacrylic acid | 6000 | 0.36 |
| Example 6 | EEDA | 1 | 2 | -0.87 | 0.44 | Polyacrylic acid | 6000 | 0.36 |
| Example 7 | EEDA | 1 | 2 | -0.87 | 0.44 | Polyacrylic acid | 6000 | 0.36 |
| Example 8 | EEDA | 1 | 2 | -0.87 | 0.44 | Polyacrylic acid | 6000 | 0.36 |
| Example 9 | EEDA | 1 | 2 | -0.87 | 0.44 | Polyacrylic acid | 6000 | 0.36 |
| Example 10 | EEDA | 1 | 2 | -0.87 | 0.44 | Polyacrylic acid | 6000 | 0.36 |
| Example 11 | EEDA | 1 | 2 | -0.87 | 0.44 | Acrylic acid-sulfonic acid copolymer | 10000 | 0.36 |
| Example 12 | N,N'-dimethyl ethylenediamine | 2 | 2 | -0.61 | 0.44 | Polyacrylic acid | 6000 | 0.36 |
| Example 13 | 1-(2-Dimethylaminoethyl) -4-methylpiperazine | 3 | 3 | -0.39 | 0.86 | Polyacrylic acid | 6000 | 0.36 |
| Example 14 | 1-Methylpiperazine | 2 | 3 | -0.24 | 0.50 | Polyacrylic acid | 6000 | 0.36 |
| Example 15 | EEDA | 1 | 2 | -0.87 | 0.44 | Polyacrylic acid | 3000 | 0.36 |
| Example 16 | EEDA | 1 | 2 | -0.87 | 0.44 | Polyacrylic acid | 2000 | 0.36 |
| Example 17 | EEDA | 1 | 2 | -0.87 | 0.44 | Polyacrylic acid | 6000 | 0.36 |
| Example 18 | EEDA | 1 | 2 | -0.87 | 0.44 | Polyacrylic acid | 6000 | 0.36 |
| Example 19 | EEDA | 1 | 2 | -0.87 | 0.44 | Polyacrylic acid | 6000 | 0.36 |
| Example 20 | EEDA | 1 | 2 | -0.87 | 0.44 | Polyacrylic acid | 6000 | 0.36 |
| Example 21 | EEDA | 1 | 2 | -0.87 | 0.44 | Polyacrylic acid | 6000 | 0.36 |
| Example 22 | 2-Aminomethyl piperidine | 1 | 2 | 0.33 | 0.57 | Polyacrylic acid | 6000 | 0.36 |
| Example 23 | 1-Ethylpiperazine | 2 | 3 | 0.29 | 0.57 | Polyacrylic acid | 6000 | 0.36 |
| Example 24 | N-butyl ethylenediamine | 1 | 2 | 0.19 | 0.58 | Polyacrylic acid | 6000 | 0.36 |
| Example 25 | EEDA | 1 | 2 | -0.87 | 0.44 | Polyacrylic acid | 6000 | 0.12 |
| Example 26 | EEDA | 1 | 2 | -0.87 | 0.44 | Polyacrylic acid | 6000 | 0.36 |
| Example 27 | EEDA | 1 | 2 | -0.87 | 0.44 | Polyacrylic acid | 6000 | 0.36 |
| Example 28 | EEDA | 1 | 2 | -0.87 | 0.44 | Polyacrylic acid | 6000 | 0.36 |
| Example 29 | EEDA | 1 | 2 | -0.87 | 0.44 | Polyacrylic acid | 6000 | 0.36 |
| Example 30 | EEDA | 1 | 2 | -0.87 | 0.44 | Polyacrylic acid | 6000 | 0.36 |
| Example 31 | EEDA | 1 | 2 | -0.87 | 0.44 | Polyacrylic acid | 6000 | 0.36 |
| Example 32 | EEDA | 1 | 2 | -0.87 | 0.44 | Polyacrylic acid | 6000 | 0.36 |
| Example 33 | EEDA | 1 | 2 | -0.87 | 0.44 | Polyacrylic acid | 6000 | 0.36 |
| Example 34 | EEDA | 1 | 2 | -0.87 | 0.44 | Polyacrylic acid | 6000 | 0.36 |
| Example 35 | EEDA | 1 | 2 | -0.87 | 0.44 | Polyacrylic acid | 6000 | 0.36 |
| Example 36 | EEDA | 1 | 2 | -0.87 | 0.44 | Polyacrylic acid | 6000 | 0.36 |
| Example 37 | EEDA | 1 | 2 | -0.87 | 0.44 | Polyacrylic acid | 6000 | 0.36 |
| Example 38 | EEDA | 1 | 2 | -0.87 | 0.44 | Polyacrylic acid | 6000 | 0.36 |
| Example 39 | EEDA | 1 | 2 | -0.87 | 0.44 | Polyacrylic acid | 6000 | 0.36 |
| Example 40 | EEDA | 1 | 2 | -0.87 | 0.44 | Polyacrylic acid | 6000 | 0.36 |
| Example 41 | EEDA | 1 | 2 | -0.87 | 0.44 | Polyacrylic acid | 6000 | 0.36 |
| Example 42 | EEDA | 1 | 2 | -0.87 | 0.44 | Polyacrylic acid | 6000 | 0.36 |
| Example 43 | EEDA | 1 | 2 | -0.87 | 0.44 | Polyacrylic acid | 6000 | 0.36 |

**[Table 2]**

| Table 2 | Cleaning solution for semiconductor substrate | | | | | |
|---|---|---|---|---|---|---|
| | pH modifier | | | | Corrosion inhibitor | |
| | Type | Content (% by mass) | Type | Content (% by mass) | Type | Content (% by mass) |
| Comparative Example 1 | ETMAH | 1.74 | - | - | Adenine | 0.038 |
| Comparative Example 2 | ETMAH | 1.74 | - | - | Adenine | 0.038 |
| Comparative Example 3 | ETMAH | 1.74 | - | - | Adenine | 0.038 |
| Example 1 | ETMAH | 1.74 | - | - | Adenine | 0.038 |
| Example 2 | ETMAH | 1.74 | - | - | Adenine | 0.038 |
| Example 3 | ETMAH | 1.74 | - | - | Adenine | 0.038 |
| Example 4 | ETMAH | 1.74 | - | - | 6-Benzyladenine | 0.038 |
| Example 5 | ETMAH | 1.74 | - | - | Adenosine | 0.038 |
| Example 6 | ETMAH | 1.74 | - | - | Xanthine | 0.038 |
| Example 7 | ETMAH | 1.74 | - | - | Xanthine | 0.038 |
| Example 8 | ETMAH | 1.74 | Choline | 3.20 | Adenine | 0.038 |
| Example 9 | ETMAH | 1.74 | - | - | Adenine | 0.038 |
| Example 10 | Choline | 3.20 | - | - | Adenine | 0.038 |
| Example 11 | ETMAH | 1.74 | - | - | Adenine | 0.038 |
| Example 12 | ETMAH | 1.74 | - | - | Adenine | 0.038 |
| Example 13 | ETMAH | 1.74 | - | - | Adenine | 0.038 |
| Example 14 | ETMAH | 1.74 | - | - | Adenine | 0.038 |
| Example 15 | ETMAH | 1.74 | - | - | Adenine | 0.038 |
| Example 16 | ETMAH | 1.74 | - | - | Adenine | 0.038 |
| Example 17 | ETMAH | 1.11 | - | - | Adenine | 0.038 |
| Example 18 | ETMAH | 0.48 | - | - | Adenine | 0.038 |
| Example 19 | ETMAH | 1.74 | - | - | - | - |
| Example 20 | ETMAH | 1.74 | - | - | Benzotriazole | 0.038 |
| Example 21 | ETMAH | 1.74 | - | - | 5-Methyl benzotriazole | 0.038 |
| Example 22 | ETMAH | 1.74 | - | - | Adenine | 0.038 |
| Example 23 | ETMAH | 1.74 | - | - | Adenine | 0.038 |
| Example 24 | ETMAH | 1.74 | - | - | Adenine | 0.038 |
| Example 25 | ETMAH | 1.74 | - | - | Adenine | 0.038 |
| Example 26 | ETMAH | 1.74 | - | - | Pyrazole | 0.038 |
| Example 27 | ETMAH | 1.74 | - | - | Imidazole | 0.038 |
| Example 28 | ETMAH | 1.74 | - | - | 3-Amino-5-tert-butyl-1H-pyrazole | 0.038 |
| Example 29 | ETMAH | 1.74 | - | - | 5-Amino-1H-tetrazole | 0.038 |
| Example 30 | ETMAH | 1.74 | - | - | 4-Methylpyrazole | 0.038 |
| Example 31 | ETMAH | 1.74 | - | - | Adenine | 0.038 |
| Example 32 | ETMAH | 1.74 | - | - | Imidazole | 0.038 |
| Example 33 | ETMAH | 1.74 | - | - | 3-Amino-5-tert-butyl-1H-pyrazole | 0.038 |
| Example 34 | ETMAH | 1.74 | - | - | 5-Amino-1H-tetrazole | 0.038 |
| Example 35 | ETMAH | 1.74 | - | - | Imidazole | 0.038 |
| Example 36 | ETMAH | 1.74 | - | - | Imidazole | 0.038 |
| Example 37 | ETMAH | 1.74 | - | - | Imidazole | 0.038 |
| Example 38 | ETMAH | 1.74 | - | - | Imidazole | 0.038 |
| Example 39 | THEMAH | 3.56 | - | - | Imidazole | 0.038 |
| Example 40 | THEMAH | 3.56 | - | - | Imidazole | 0.038 |
| Example 41 | THEMAH | 3.56 | - | - | 3-Amino-5-tert-butyl-1H-pyrazole | 0.038 |
| Example 42 | THEMAH | 3.56 | - | - | Adenine | 0.038 |
| Example 43 | ETMAH | 1.74 | - | - | Adenine | 0.06 |

**[Table 3]**

| Table 3 | Cleaning solution for semiconductor substrate | | | | Evaluation | | |
|---|---|---|---|---|---|---|---|
| | Additive | | | | Cleaning ability | | Ability to inhibit corrosion of Cu |
| | Type | Content (% by mass) | Dilution factor (mass ratio) | pH after dilution | Cu | SiCN | |
| Comparative Example 1 | - | - | ×100 | 11.3 | A | A | D |
| Comparative Example 2 | - | - | ×100 | 11.3 | D | A | B |
| Comparative Example 3 | - | - | ×100 | 11.3 | A | D | A |
| Example 1 | - | - | ×100 | 11.2 | A | A | A |
| Example 2 | - | - | ×100 | 11.3 | A | A | A |
| Example 3 | - | - | ×100 | 11.2 | A | A | A |
| Example 4 | - | - | ×100 | 11.3 | A | A | A |
| Example 5 | - | - | ×100 | 11.3 | A | A | A |
| Example 6 | - | - | ×100 | 11.3 | A | A | A |
| Example 7 | - | - | ×100 | 11.3 | A | A | A |
| Example 8 | - | - | ×100 | 11.3 | A | A | A |
| Example 9 | - | - | ×10 | 11.9 | A | A | A |
| Example 10 | - | - | ×100 | 11.3 | A | A | A |
| Example 11 | - | - | ×100 | 11.3 | A | A | A |
| Example 12 | - | - | ×100 | 11.3 | B | A | A |
| Example 13 | - | - | ×100 | 11.2 | B | A | A |
| Example 14 | - | - | ×100 | 11.3 | B | A | A |
| Example 15 | - | - | ×100 | 11.2 | A | B | B |
| Example 16 | - | - | ×100 | 11.2 | A | B | C |
| Example 17 | - | - | ×100 | 10.8 | B | A | A |
| Example 18 | - | - | ×100 | 9.7 | C | A | A |
| Example 19 | - | - | ×100 | 11.2 | A | A | C |
| Example 20 | - | - | ×100 | 11.3 | C | A | B |
| Example 21 | - | - | ×100 | 11.3 | C | A | B |
| Example 22 | - | - | ×100 | 11.3 | B | A | A |
| Example 23 | - | - | ×100 | 11.3 | C | A | A |
| Example 24 | - | - | ×100 | 11.3 | B | A | A |
| Example 25 | - | - | ×100 | 11.3 | A | A | A |
| Example 26 | - | - | ×100 | 11.3 | A | A | A |
| Example 27 | - | - | ×100 | 11.3 | A | A | A |
| Example 28 | - | - | ×100 | 11.3 | A | A | A |
| Example 29 | - | - | ×100 | 11.3 | A | A | A |
| Example 30 | - | - | ×100 | 11.3 | A | A | A |
| Example 31 | Citric acid | 0.100 | ×100 | 11.2 | A | A | A |
| Example 32 | Citric acid | 0.100 | ×100 | 11.2 | A | A | A |
| Example 33 | Citric acid | 0.100 | ×100 | 11.2 | A | A | A |
| Example 34 | Citric acid | 0.100 | ×100 | 11.2 | A | A | A |
| Example 35 | Tartaric acid | 0.100 | ×100 | 11.2 | A | A | A |
| Example 36 | Malonic acid | 0.100 | ×100 | 11.2 | A | A | A |
| Example 37 | Succinic acid | 0.100 | ×100 | 11.2 | A | A | A |
| Example 38 | Malic acid | 0.100 | ×100 | 11.2 | A | A | A |
| Example 39 | Tartaric acid | 0.100 | ×100 | 11.2 | A | A | A |
| Example 40 | Malonic acid | 0.100 | ×100 | 11.2 | A | A | A |
| Example 41 | Citric acid | 0.100 | ×100 | 11.2 | A | A | A |
| Example 42 | Citric acid | 0.100 | ×100 | 11.2 | A | A | A |
| Example 43 | Citric acid | 0.005 | ×100 | 11.2 | B | A | A |

As can be seen from the results in the tables, when the cleaning solution of the invention is used for a target object having a copper surface and a silicon carbonitride surface subjected to chemical mechanical polishing processing, the ability of the cleaning solution to clean the copper surface and the silicon carbonitride surface is high, and the amount of corrosion of the copper surface is small.

As can be seen from the comparison between Examples 1 to 11 and Examples 12 to 14, when R₁ and R₂ in the compound represented by formula (A) are each a hydrogen atom and at least one of R₃ or R₄ is an alkyl group optionally having a substituent other than a carboxy group and a phosphonic acid group, the ability to clean the copper surface is higher.

As can be seen from the comparison between Examples 1 to 11 and Examples 15 and 16, when the weight average molecular weight of the polymer is 3000 or more, the amount of corrosion of the copper surface is smaller. When the weight average molecular weight of the polymer is 4000 or more, the ability to clean the silicon carbonitride surface is higher, and the amount of corrosion of the copper surface is further reduced.

As can be seen from the comparison between Examples 1 to 11 and Examples 17 and 18, when the pH of the cleaning solution for a semiconductor substrate is 10.0 or more, the ability to clean the copper surface is higher. When the pH is 11.0 or more, the ability to clean the copper surface is even higher.

As can be seen from the comparison between Examples 1 to 11 and Example 19, when the cleaning solution for a semiconductor substrate further includes a corrosion inhibitor, the amount of corrosion of the copper surface is smaller.

As can be seen from the comparison between Examples 1 to 11 and Examples 20 to 21, when the corrosion inhibitor includes at least one of the compound represented by formula (C) or the compound represented by formula (D), the ability to clean the copper surface is higher, and the amount of corrosion of the copper surface is smaller.

As can be seen from the comparison between Examples 1 to 11 and Examples 22 to 24, when at least one of the condition that the ClogP value of the compound represented by formula (A) is a negative value or the condition that the number of carbon atoms in the compound represented by formula (A) is 5 or less is satisfied, the ability to clean the copper surface is higher.

## Claims

1. A cleaning solution for a semiconductor substrate, the cleaning solution comprising:
a compound represented by formula (A); and
a polymer having a group selected from the group consisting of a carboxy group and salts thereof and a sulfonic acid group and salts thereof,
wherein the cleaning solution has a pH of 7.5 or more: 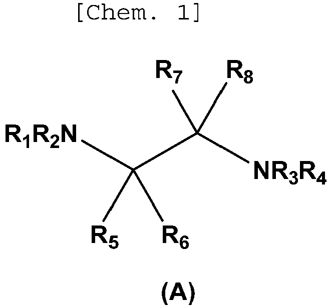
wherein, in formula (A),
R₁ to R₈ each independently represent a hydrogen atom or an alkyl group optionally having a substituent other than a carboxy group and a phosphonic acid group;
at least one of R₁, R₂, R₃, or R₄ represents an alkyl group optionally having a substituent other than a carboxy group, a phosphonic acid group, and an amino group;
R₃ and R₇ may be bonded together via a single bond or a divalent linking group to form a ring; and R₁ and R₃ may be bonded together via a single bond or a divalent linking group to form a ring.

2. The cleaning solution for a semiconductor substrate according to claim 1, wherein R₅ and R₆ are each a hydrogen atom.

3. The cleaning solution for a semiconductor substrate according to claim 1, wherein R₁ to R₈ each independently represent a hydrogen atom or an alkyl group optionally having a substituent other than a carboxy group, a phosphonic acid group, and a hydroxy group, and
wherein at least one of R₁, R₂, R₃, or R₄ represents an alkyl group optionally having a substituent other than a carboxy group, a phosphonic acid group, a hydroxy group, and an amino group.

4. The cleaning solution for a semiconductor substrate according to claim 1, wherein R₁ and R₂ are each a hydrogen atom, and wherein at least one of R₃ or R₄ is an alkyl group optionally having a substituent other than a carboxy group and a phosphonic acid group.

5. The cleaning solution for a semiconductor substrate according to claim 1, wherein the polymer has a weight average molecular weight of 4000 or more.

6. The cleaning solution for a semiconductor substrate according to claim 1, wherein the cleaning solution has a pH of 10.0 or more.

7. The cleaning solution for a semiconductor substrate according to claim 1, wherein the cleaning solution has a pH of 11.0 or more.

8. The cleaning solution for a semiconductor substrate according to claim 1, wherein the cleaning solution further comprises a corrosion inhibitor.

9. The cleaning solution for a semiconductor substrate according to claim 8, wherein the corrosion inhibitor includes at least one of a compound represented by formula (C) or a compound represented by formula (D): 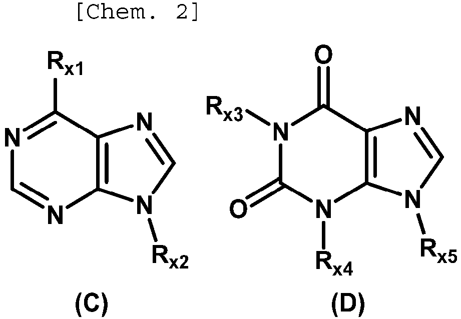
wherein, in formulas (C) and (D),
Rₓ₁ to Rₓ₅ each independently represent a hydrogen atom, an alkyl group optionally having a substituent, an amino group optionally having a substituent, a thiol group, a hydroxy group, a halogen atom, a sugar group optionally having a substituent, or a polyoxyalkylene group-containing group optionally having a substituent.

10. The cleaning solution for a semiconductor substrate according to claim 1, wherein a ClogP value of the compound represented by formula (A) above is a negative value.

11. The cleaning solution for a semiconductor substrate according to claim 1, wherein the number of carbon atoms in the compound represented by formula (A) above is 5 or less.

12. The cleaning solution for a semiconductor substrate according to claim 1, wherein the cleaning solution comprises water.

13. The cleaning solution for a semiconductor substrate according to claim 1, wherein the cleaning solution is used to clean a target object subjected to chemical mechanical polishing processing.

14. The cleaning solution for a semiconductor substrate according to claim 13, wherein the target object has a copper surface and a silicon carbonitride surface that have been subjected to chemical mechanical polishing processing, and wherein the cleaning solution is used to clean the copper surface and the silicon carbonitride surface.

15. A method for cleaning a target object, the method comprising the step of bringing a target object having a copper surface and a silicon carbonitride surface that have been subjected to chemical mechanical polishing processing into contact with the cleaning solution for a semiconductor substrate according to any one of claims 1 to 14.

16. The method for cleaning a target object according to claim 15, wherein the step is cleaning with a polishing pad, buff cleaning, cleaning by an immersion method, spin cleaning, or scrub cleaning.

17. A method for manufacturing a semiconductor device, the method comprising the method for cleaning a target object according to claim 15.
